# EUROPÄISCHE PATENTSCHRIFT

(11) **EP 3 441 958 B1**
(45) Veröffentlichungstag und Bekanntmachung des Hinweises auf die Patenterteilung: **06.05.2020**
(21) Anmeldenummer: 17020350.9
(22) Anmeldetag: 10.08.2017
(51) Int. Cl.: G08B 29/12, G08B 17/06

(54) **ANSTEUER- UND ÜBERWACHUNGSMODUL**
CONTROL AND MONITORING MODULE
MODULE DE COMMANDE ET DE SURVEILLANCE

(43) Veröffentlichungstag der Anmeldung: 13.02.2019
(73) Patentinhaber: Wagner Group GmbH, 30853 Langenhagen (DE)
(72) Erfinder: Daniault, Florence, 30655 Hannover (DE); Lewonig, Horst, 30655 Hannover (DE); Eickhorn, Frank, 42657 Solingen (DE)
(74) Vertreter: Götz, Georg Alois

(56) Entgegenhaltungen:
- EP-A1- 2 093 737
- EP-A1- 2 393 073
- EP-A1- 2 804 163

## Beschreibung

Die vorliegende Erfindung betrifft ein Ansteuer- und Überwachungsmodul zum Ansteuern mindestens eines dem Ansteuer- und Überwachungsmodul zugeordneten Aktors und zum Überwachen mindestens einer Signal- und/oder Versorgungsleitung zu dem Ansteuer- und Überwachungsmodul und/oder zu dem mindestens einen Aktor.

Die Erfindung betrifft ferner ein System, insbesondere Brandschutzsystem, welches mindestens einen Aktor, eine Systemsteuerung zur Versorgung des Aktors mit Signalen, eine Energieversorgungseinrichtung zur Versorgung des Aktors mit elektrischer Energie und mindestens eine Signal- und/oder Versorgungsleitung aufweist, welche zwischen der Systemsteuerung und/oder der Energieversorgungseinrichtung und dem mindestens einen Aktor verläuft, wobei dem mindestens einen Aktor ein Ansteuer- und Überwachungsmodul zugeordnet ist.

Ferner betrifft die Erfindung ein Verfahren zum Betreiben eines entsprechenden Ansteuer- und Überwachungsmoduls.

An Brandschutzsysteme, wie z.B. Brandvermeidungs-, Brandmelde- oder Löschanlagen, werden hohe Ansprüche an die Zuverlässigkeit und Betriebssicherheit gestellt, um beispielsweise Industrieanlagen, Lagereinrichtungen und sonstige wertvolle Objekte sowie insbesondere auch Personen vor Bränden zu schützen. Hierzu umfasst der Brandschutz einerseits präventive Maßnahmen wie beispielsweise die Herabsetzung des Sauerstoffgehaltes in den zu schützenden Bereichen. Andererseits enthält er auch reaktive Maßnahmen wie die Ansteuerung von Aktoren, die Alarmierungsmittel wie Blitzleuchten, Hupen oder Leuchtfelder, aber auch beispielsweise Stellmotoren an Brandschutztüren oder Ventile in Löschanlagen umfassen können. Da insbesondere reaktive Schutzmaßnahmen aufgrund des bereits bestehenden Brandes höchst sicherheitsrelevant sind, muss die einwandfreie Funktionsfähigkeit der Aktoren jederzeit sichergestellt sein. Aber auch bei präventiven Maßnahmen ist die zuverlässige Funktion der Aktoren zur Erfüllung der Brandschutzfunktion oder bei Fehlfunktionen des präventiven Brandschutzsystems dauerhaft zu gewährleisten. So müssen beispielsweise Ventile zur Einleitung sauerstoffreduzierter Luft jederzeit auf Anforderung öffnen, um die für den präventiven Brandschutz erforderliche Aufrechterhaltung einer reduzierten Sauerstoffkonzentration in dem geschützten Bereich zu gewährleisten. Sollte der reduzierte Sauerstoffgehalt durch einen technischen Fehler des Brandschutzsystems bis unter eine für Personen gesundheitsgefährdende Konzentration sinken, müssen die gleichen Ventile zuverlässig schließen, um die weitere Einleitung sauerstoffreduzierter Luft zu verhindern. Zudem müssen in einem solchen Fall Alarmierungsmittel verlässlich eingeschaltet werden können, um Personen zu warnen und zum Verlassen des geschützten Bereiches aufzufordern.

In der Regel werden solche Aktoren von entsprechenden Systemsteuerungen eines Brandschutzsystems über Versorgungs- und Signalleitungen, in der Regel Zweidraht- oder Mehrdrahtleitungen, angesteuert, wobei im Ereignisfall eine spezifikationsgerechte Ansteuerspannung zu den Aktoren geschaltet wird. Der Ereignisfall kann beispielsweise ein Brandereignis, d.h. ein durch einen Brandmelder oder Handfeuermelder ausgelöstes Branderkennungssignal sein.

Nachdem derartige Aktoren eines Brandschutzsystems nur sehr selten - im Idealfall nie - betätigt werden, stellt es eine Herausforderung dar, den konkreten Betriebszustand der Aktoren und/oder der Signal- und/oder Versorgungsleitungen des Brandschutzsystems ständig und insbesondere ohne Beeinträchtigung des normalen Tagesablaufes im Bereich des Brandschutzsystems sicherzustellen. Natürlich wäre es möglich, in regelmäßigen Abständen die Aktoren des Brandschutzsystems durch Probeaktivierung zu überprüfen, jedoch müssten dann die sich im Bereich des Brandschutzsystems befindlichen Personen bei jeder Überprüfung entsprechend vorbereitet werden.

Durch die Norm EN 54-13 2005, den Normenentwurf EN 54-2 2016 und die VdS 3156 2012 *Elektrische Systemsteuerungen für Sauerstoffreduzierungsanlagen* sind die Anforderungen an die Funktionsfähigkeit eines leitungsgebundenen Übertragungsweges einer Gefahrenmelde- bzw. Sauerstoffreduzierungsanlage erheblich erhöht worden. Gemäß der EN 54-13 2005 muss nunmehr nicht nur eine Störung gemeldet werden, wenn eine vollständige Unterbrechung des Übertragungsweges, also ein einem unendlich hohen Leitungswiderstand entsprechenden Leitungsbruch vorliegt, sondern bereits dann, wenn bzw. bevor eine Leitung einer Brandmeldeanlage eine Ansteuerfunktion nicht mehr ausführen kann. Dies kann damit begründet werden, dass an die Brandmeldeanlage angeschlossene Aktoren, insbesondere eine Mehrzahl von Alarmmitteln, gleichzeitig eine plötzliche hohe elektrische Leistung verbrauchen und bereits ein geringfügig erhöhter oder reduzierter Leitungswiderstand dazu führen kann, dass diese Leistung nicht mehr ausreichend über den Übertragungsweg bereitgestellt werden kann. Ein erhöhter oder reduzierter Leitungswiderstand kann beispielsweise über die Zeit durch Feuchtigkeit, Verschmutzung und Korrosion von Leiterabschnitten oder Kontakten entstehen, weswegen dieser Effekt häufig als "schleichende Unterbrechung" bzw. "schleichender Kurzschluss" bezeichnet wird. Daher fordert die EN 54-13 2005, dass ab einem Leitungswiderstand, bei dem die sichere Ansteuerung über einen Übertragungsweg nicht mehr gewährleistet werden kann, eine Störungsmeldung abgesetzt wird. Die Norm legt dabei enge Toleranzgrenzen von 10 % zugrunde: Bei einem Wert von 0,9 bzw. 1,1 des als zu hohen bzw. zu niedrigen festgelegten Widerstandswertes muss die Aktoransteuerung noch einwandfrei und ohne Störungsmeldung funktionieren. Entsprechend ergibt sich die Anforderung, den Leitungswiderstand der Übertragungswege genau zu überwachen und bei Über- oder Unterschreitung eines oben oder unteren Widerstandsschwellwertes eine Störungsmeldung zu erzeugen. Daraus abgeleitet muss eine normgerechte Anlage sicherstellen, dass jeder Übertragungsweg unter bestimmungsgemäßen Lastbedingungen an den betreffenden Bestandteilen, insbesondere Aktoren, die für die Funktion dieses Bestandteils mindestens notwendige Leistung liefert. Eine zu geringe Leistung würde bei Lieferung des benötigten Laststroms anhand eines Spannungseinbruchs erkennbar werden.

Die EP 2105898 A2 beschreibt ein Verfahren zur Prüfung eines leitungsgebundenen Übertragungsweges einer Gefahrenmeldeanlage auf unzulässig hohen Widerstand durch Erzeugung eines Stromes auf dem mit einem Endmodul abgeschlossenen Übertragungsweg. Das Endmodul erzeugt den Strom, misst und vergleicht die Spannung an dem Endmodul mit einem Sollwert und generiert eine Fehlermeldung bei Unterschreitung des Sollwertes. Erfindungsgemäß wird der Strom bis auf einen vorgegebenen Wert steigend erzeugt, beispielsweise in Form einer Stromrampe. Ferner wird eine entsprechende Gefahrenmeldeanlage mit einer Zentrale, einer Leitung und einem Endmodul beschrieben, wobei das Endmodul die Leitung auf Fehler durch Kurzschluss oder unzulässig hohen Widerstand prüft.

Die EP 2804163 A1 beschreibt ein Verfahren und eine Vorrichtung zur Messung eines Leitungswiderstandes und zur Bestimmung von Störungen von Steuerleitungen in einem Gefahrenmelde- und Steuerungssystem, wobei die Steuerleitungen eine Steuerungsvorrichtung mit einem Aktor verbinden und die Steuerungsvorrichtung im Ereignisfall den Aktor mit einer Ansteuerspannung ansteuert. Am oder im Aktor ist ein Überwachungsmodul angeordnet. Auch Konfigurationen mit mehreren Aktoren sind erfindungsgemäß nicht ausgeschlossen. Die Steuerungsvorrichtung weist eine über einen Mikrocontroller zuschaltbare Stromsenke oder einen zuschaltbaren Lastwiderstand auf. Bei einer Leitungsprüfung wird die Spannungsversorgung des Aktors von Seiten der Steuerungsvorrichtung abgeschaltet und eine konstante Spannungsversorgung aus einem Energiespeicher, z.B. Kondensator, von dem Überwachungsmodul bereitgestellt.

Nachteilig bei den bekannten Verfahren und Vorrichtungen zur Leitungsüberwachung und -prüfung ist, dass die zugrundeliegenden Prüf- und Überwachungsmechanismen der Komplexität und Individualität der überwachten Systeme nicht ausreichend gerecht werden können und somit entweder aufwendig an diese anzupassen sind oder zu unzuverlässigen Ergebnissen führen, beispielsweise trotz eines zunehmenden oder reduzierten Leitungswiderstandes keine Störungsmeldung absetzen oder umgekehrt ohne Vorliegen eines kritisch veränderten Leitungswiderstandes eine (nicht vorhandene) Störung feststellen. Zudem sind die bekannten Verfahren und Vorrichtungen unflexibel bei einer Veränderung des überwachten Brandschutzsystems, etwa bei der Ergänzung oder Entfernung von Aktoren.
Der Erfindung liegt daher die Aufgabe zugrunde, ein flexibleres Ansteuer- und Überwachungsmodul zum Ansteuern mindestens eines dem Ansteuer- und Überwachungsmodul zugeordneten Aktors und zum Überwachen einer Signal- und/oder Versorgungsleitung zu dem Ansteuer- und Überwachungsmodul und/oder zu dem mindestens einen Aktor anzugeben, wobei dieses Ansteuer-und Überwachungsmodul ausgebildet ist, die mindestens eine Signal- und/oder Versorgungsleitung mit hoher Zuverlässigkeit auf eine Ansteuerfunktion gefährdenden erhöhten bzw. reduzierten Leitungswiderstand gemäß der Norm EN 54-13 2005 zu überwachen.

Eine weitere der vorliegenden Erfindung zugrunde liegende Aufgabe besteht darin, ein System, insbesondere Brandschutzsystem, anzugeben, welches mindestens einen Aktor sowie eine Systemsteuerung zur Versorgung des mindestens einen Aktors mit Signalen, eine Energieversorgungseinrichtung zur Versorgung des mindestens einen Aktors mit elektrischer Energie, und mindestens eine Signal- und/oder Versorgungsleitung aufweist, welche zwischen der Systemsteuerung und/oder der Energieversorgungseinrichtung und dem mindestens einen Aktor verläuft, wobei dieses System, insbesondere Brandschutzsystem, ausgelegt ist, mit hoher Zuverlässigkeit und Flexibilität die Signal- und/oder Versorgungsleitung auf eine Ansteuerfunktion gefährdenden erhöhten bzw. reduzierten Leitungswiderstand gemäß der Norm EN 54-13 zu überwachen.

Des Weiteren soll ein entsprechendes Verfahren zum Betreiben eines Ansteuer- und Überwachungsmoduls angegeben werden.

Im Hinblick auf das Ansteuer- und Überwachungsmodul wird die der Erfindung zugrunde liegende Aufgabe durch den Gegenstand des unabhängigen Patentanspruches 1 und im Hinblick auf das System, insbesondere Brandschutzsystem, durch den Gegenstand des nebengeordneten Patentanspruches 8 gelöst. Im Hinblick auf das Verfahren wird die der Erfindung zugrunde liegende Aufgabe durch den Gegenstand des nebengeordneten Patentanspruches 15 gelöst.

Demnach umfasst das erfindungsgemäße Ansteuer- und Überwachungsmodul eine Ansteuereinrichtung zum Ansteuern des mindestens einen Aktors, eine Messeinrichtung zum Ermitteln einer Strom- und/oder Leistungsaufnahme des mindestens einen Aktors und zum Ermitteln einer an dem Ansteuer- und Überwachungsmodul und/oder einer an dem Aktor anliegenden Spannung, sowie eine Prüfeinrichtung zum Simulieren einer Strom- und/oder Leistungsaufnahme des mindestens einen Aktors. Dabei ist das Ansteuer- und Überwachungsmodul ausgebildet, eine Störung der mindestens einen Signal- und/oder Versorgungsleitung zu dem Ansteuer- und Überwachungsmodul und/oder zu dem mindestens einen dem Ansteuer- und Überwachungsmodul zugeordneten Aktor zu erkennen, wenn bei einer von der Prüfeinrichtung des Ansteuer- und Überwachungsmoduls durchgeführten Simulation eine an dem Ansteuer- und Überwachungsmodul und/oder eine an dem Aktor anliegende Spannung einen vorab festgelegten oberen Spannungsschwellwert überschreitet oder einen vorab festgelegten unteren Spannungsschwellwert unterschreitet.

Durch das erfindungsgemäße Ansteuer- und Überwachungsmodul ist es auf eine überraschend einfache Weise möglich, durch Simulieren eines Lastfalls unter *realen* und *individuellen* Bedingungen eine besonders sichere und zuverlässige Aussage über die Funktionsfähigkeit der Signal- und Versorgungsleitungen treffen zu können. Die Leitungsprüfung und -überwachung erfolgt nicht wie beim Stand der Technik auf Basis theoretischer Annahmen und Berechnungen zu prognostizierten Lastfällen, sondern auf tatsächlich gemessenen Strom- und/oder Leistungsaufnahmen der beteiligten Aktoren, die zudem im eingeschalteten Zustand der Aktoren auch noch zeitabhängig variieren können, und unter Berücksichtigung der tatsächlich verlegten Kabeltypen und -längen. Durch das Nachstellen der gemessenen elektrischen Größen kann ein realer Lastfall exakt simuliert und die für die Ansteuerung des Aktors zur Verfügung stehende Energie anhand der an dem Aktor bzw. an dem Ansteuer- und Überwachungsmodul anliegenden Spannung überprüft werden.

Das Ansteuer- und Überwachungsmodul ist beispielsweise ein Kompaktgerät mit einem Gehäuse und einer Grundplatine, auf der sich unter anderem die Ansteuer-, Mess- und Prüfeinrichtung sowie die notwendigen Anschlüsse für die Signal- und Versorgungsleitungen und Aktorenausgänge befinden. Es können zudem noch Konfigurationsschalter und LED-Indikatoren zur Visualisierung von Gerätezuständen an dem Modul angeordnet sein. Das Ansteuer- und Überwachungsmodul ist bevorzugt in unmittelbarer Nähe oder direkt an den Aktoren angeordnet. Dadurch wird gewährleistet, dass nahezu der gesamte Übertragungsweg für elektrische Signale und Energie von dem Modul überwacht wird.

Die Ansteuereinrichtung des Ansteuer- und Überwachungsmoduls ist in ihrer einfachsten Form ein Schalter, beispielsweise ein Relais, Schaltkontakt oder auch ein elektronischer Schalter wie ein Transistor. Die Ansteuereinrichtung dient dazu, die von der Signal- und Versorgungsleitung beim Ansteuer- und Überwachungsmodul ankommende elektrische Energie zum Aktivieren des mindestens einen Aktors zu diesem durchzuschalten. Der mindestens eine Aktor wird somit nur bei aktivierter Ansteuereinrichtung mit Energie versorgt.

Die Messeinrichtung umfasst Messschaltungen zur Messung der elektrischen Größen Stromstärke, Leistung und/oder Spannung. Die Messwerte können beispielsweise mithilfe einer Modulsteuerung, etwa in Form eines Mikrocontrollers oder Mikroprozessors in dem Ansteuer- und Überwachungsmodul verarbeitet und mit jeweiligen oberen und unteren Schwellwerten verglichen werden. Die Messungen können während eines Messvorgangs punktuell, bevorzugt jedoch kontinuierlich oder zyklisch, beispielsweise einmal pro Minute, und mit einer Messdauer von beispielsweise 10 bis 20 Sekunden erfolgen. Selbstverständlich ist auch eine kürzere Messdauer im Bereich von Millisekunden denkbar.

Die Prüfeinrichtung zum Simulieren einer Strom- und/oder Leistungsaufnahme des mindestens einen Aktors ist eine einstellbare ohmsche oder elektronische Last, beispielsweise eine Stromsenke. Sie dient dazu, den zuvor von der Messeinrichtung gemessenen, tatsächlichen Energieverbrauch des mindestens einen Aktors nachzubilden und dadurch eine reale Ansteuerung des Aktors im Rahmen einer Leitungsprüfung zu ersetzen. Die Prüfeinrichtung kann beispielsweise mithilfe einer Modulsteuerung, etwa mittels eines Mikrocontrollers oder Mikroprozessors, angesteuert werden, sodass diese anhand der zuvor verarbeiteten Messergebnisse der Messeinrichtungen die Simulationswerte der elektrischen Größen an der Prüfeinrichtung einstellt.

Unter einer Störung der mindestens einen Signal- und/oder Versorgungsleitung wird ein unzulässig hoher Widerstand oder ein unzulässig niedriger Widerstand gemäß der Norm EN54-13 2005 verstanden. In diesem Zusammenhang bedeutet "unzulässig", dass die geforderte Ansteuerfunktion ab einem zu hohen oder zu niedrigen Widerstand möglicherweise nicht mehr gewährleistet werden kann, weil die über die Signal- und/oder Versorgungsleitung an Aktoren übertragbare elektrische Leistung durch die Widerstandsveränderung nicht mehr ausreichend ist.

Bevorzugt erzeugt das Ansteuer- und Überwachungsmodul eine Fehler- bzw. Störungsmeldung, wenn dieses wiederholt und insbesondere aufeinanderfolgend eine Störung der Signal- und/oder Versorgungsleitung erkennt. Dadurch wird gewährleistet, dass tatsächlich eine Störung der Signal-und/oder Versorgungsleitung vorliegt und keine fehlerhafte Störungsmeldung aufgrund eines kurzzeitigen Simulations- oder Messfehlers erfolgt. Diese Ausführungsform kann beispielsweise mithilfe eines internen Fehlerzählers in dem Ansteuer- und Überwachungsmodul umgesetzt werden.

Gemäß einer Weiterbildung des erfindungsgemäßen Ansteuer- und Überwachungsmoduls ist dieses ferner ausgebildet, eine Störung der mindestens einen Signal- und/oder Versorgungsleitung zu erkennen, wenn bei einem Ansteuern des mindestens einen Aktors
▪ eine Stromaufnahme des mindestens einen Aktors einen vorab festgelegten oberen Stromschwellwert überschreitet oder einen vorab festgelegten unteren Stromschwellwert unterschreitet; und/oder
▪ wenn eine Leistungsaufnahme des mindestens einen Aktors einen vorab festgelegten oberen Leistungsschwellwert überschreitet oder einen vorab festgelegten unteren Leistungsschwellwert unterschreitet; und/oder
▪ wenn eine an dem Ansteuer- und Überwachungsmodul und/oder dem Aktor anliegende Spannung einen vorab festgelegten oberen Spannungsschwellwert überschreitet oder einen vorab festgelegten unteren Spannungsschwellwert unterschreitet.

Somit kann nicht nur bei einer durch die Prüfeinrichtung durchgeführten Simulation der Stromund/oder Leistungsaufnahme des mindestens einen Aktors eine Störung erkannt werden, sondern auch bei einem tatsächlichen Ansteuern des Aktors durch Aktivieren bzw. Schalten der Ansteuerungseinrichtung. Dadurch kann beispielsweise auch ein defekter Aktor erkannt werden. Hierzu misst die Messeinrichtung des Ansteuer- und Überwachungsmoduls die Strom- und/oder Leistungsaufnahme des mindestens einen Aktors sowie die an dem Ansteuer- und Überwachungsmodul und/oder an dem Aktor anliegende Spannung während des Ansteuerns und vergleicht diese mit vorab festgelegten unteren bzw. oberen Schwellwerten. Bei einem insbesondere wiederholt oder aufeinanderfolgend auftretenden Über- oder Unterschreiten eines Schwellwerts wird eine Störung, z.B. "Leitungsfehler" oder "Aktorfehler", gemeldet.

Gemäß bevorzugten Realisierungen des erfindungsgemäßen Ansteuer- und Überwachungsmoduls weist das Ansteuer- und Überwachungsmodul ferner eine Speichereinrichtung auf. Diese kann zum einen die vorab festgelegten Schwellwerte der Größen Strom, Spannung und/oder Leistung speichern, zum anderen jedoch auch die von der Messeinrichtung ermittelten Werte dieser Größen. Bevorzugt handelt es sich bei der Speichereinrichtung um einen nichtflüchtigen mikroelektronischen Speicher, beispielsweise einen Speicherchip oder integrierten Schaltkreis (IC). Die Speichereinrichtung kann insbesondere in eine Modulsteuerung, beispielsweise in einen Mikrocontroller integriert sein.

Gemäß bevorzugten Ausführungsformen ist die Ansteuereinrichtung ausgebildet, in einem Anlernmodus und/oder Ansteuermodus den mindestens einen Aktor anzusteuern. Vorteilhafterweise ist die Messeinrichtung ausgebildet, in dem Anlernmodus und/oder Ansteuermodus die Stromund/oder Leistungsaufnahme des mindestens einen angesteuerten Aktors zu ermitteln. Die Prüfeinrichtung kann ausgebildet sein, in einem Überwachungsmodus die ermittelte Strom- und/oder Leistungsaufnahme des mindestens einen Aktors zu simulieren. In dem Überwachungsmodus ermittelt die Messeinrichtung bevorzugterweise die an dem Ansteuer- und Überwachungsmodul und/oder dem mindestens einen Aktor anliegende Spannung.

Dadurch, dass das Ansteuer- und Überwachungsmodul in verschiedenen Betriebszuständen wie einen Anlern-, Ansteuer- und Überwachungsmodus betreibbar ist, kann es besonders zuverlässig die für die Ansteuerung und Leitungsüberwachung erforderlichen unterschiedlichen Aufgaben erfüllen. In dem Anlernmodus "lernt" das Ansteuer- und Überwachungsmodul das Verhalten des Aktors während einer realen Ansteuerung, indem es die Strom- und/oder Leistungsaufnahme des angesteuerten Aktors misst. In einem Überwachungsmodus simuliert die Prüfeinrichtung die zuvor im Anlernmodus angelernten Werte durch Erzeugen einer elektronischen Last, beispielsweise eines elektrischen Stroms oder einer elektrischen Leistung. In einem Ansteuermodus steuert das Modul den mindestens einen Aktor real an, weil beispielsweise aufgrund einer detektierten Gefahr Alarmmittel oder Ventile zu aktivieren sind. Das Signal für einen Wechsel des Ansteuer- und Überwachungsmoduls in einen anderen Modus kann modulintern, z.B. durch eine Modulsteuerung in Form eines Mikrocontrollers, erzeugt werden, etwa wenn das Modul nach einem initialen, zeitlich begrenzten Anlernmodus in den Überwachungsmodus übergeht. Das Signal für einen Moduswechsel kann dem Ansteuer- und Überwachungsmodul jedoch auch über die von dem Ansteuer- und Überwachungsmodul überwachte Signal- und/oder Energieversorgungsleitung zugehen, beispielsweise wenn aufgrund eines Gefahrenereignisses die Aktoren aktiviert werden müssen und das Ansteuer- und Überwachungsmodul hierzu in den Ansteuermodus übergehen soll.

Grundsätzlich ist es von Vorteil, wenn die Messeinrichtung ausgebildet ist, in einem Anlernmodus und/oder Ansteuermodus zusätzlich die an dem Ansteuer- und Überwachungsmodul und/oder dem mindestens einen Aktor anliegende Spannung zu ermitteln. Dadurch ist es neben der erhöhten Zuverlässigkeit der Erkennung eines Leitungsfehlers beispielsweise auch möglich, während eines Anlern- oder Ansteuervorganges einen eventuell vorliegenden Aktorfehler zu erkennen. So kann etwa bei grundsätzlich intakter Signal- und/oder Versorgungsleitung bei einem Kurzschluss durch einen Aktor während eines Ansteuervorganges dieser Fehler zuverlässig festgestellt werden.

Gemäß bevorzugten Ausführungsformen der vorliegenden Erfindung ist die Messeinrichtung ausgebildet, in dem Anlernmodus einen zeitlichen Verlauf und/oder einen Effektivwert der Stromund/oder Leistungsaufnahme des Aktors zu ermitteln, wobei die Prüfeinrichtung ausgebildet ist, in dem Überwachungsmodus den ermittelten Effektivwert oder den ermittelten zeitlichen Verlauf der Strom- und/oder Leistungsaufnahme des mindestens einen Aktors zu simulieren. Durch das exakte Messen und Nachbilden eines zeitlichen Verlaufes einer Strom- und/oder Leistungsaufnahme ist eine besonders genaue und realistische Simulation eines Lastfalls möglich, sodass höchste Ansprüche an eine exakte Leitungsüberwachung erfüllt werden können. Der zeitliche Verlauf kann ein regelmäßiger Verlauf sein, beispielsweise in Form einer Sägezahnkurve. Die Funktion der Strom- bzw. Leistungsaufnahme in Abhängigkeit von der Zeit kann jedoch genauso gut einen unregelmäßigen Verlauf aufweisen. Durch das Ableiten eines Effektivwertes aus den gemessenen Absolutwerten wird die Simulation der gemessenen Strom- bzw. Leistungswerte hingegen praxisnah vereinfacht. Unter einem Effektivwert wird derjenige Wert einer elektrischen Größe verstanden, der an einem Verbraucher in einer repräsentativen Zeitspanne, beispielsweise 10 bis 20 Sekunden, dieselbe elektrische Energie bzw. dieselbe elektrische Leistung umsetzt. Selbstverständlich ist auch eine kürzere Messdauer im Bereich von Millisekunden denkbar. Die Effektivwertbildung kann beispielsweise softwarebasiert oder mittels an sich bekannter diskreter Schaltungen realisiert werden.. Grundsätzlich könnten auch andere Werte wie beispielsweise der gemessene Maximalwert des Stroms bzw. der Leistung einer Simulation durch die Prüfeinrichtung zugrunde gelegt werden. Jedoch hat sich insbesondere die Berechnung und Nachbildung des Effektivwertes als besonders praktikabel herausgestellt.

In einer besonders bevorzugten Ausführungsform handelt es sich bei der Prüfeinrichtung des Ansteuer- und Überwachungsmoduls um eine steuerbare Stromsenke. Diese kann in einer besonders einfachen Ausführung eine Operationsverstärkerschaltung sein und beispielsweise ein von einer Modulsteuerung, etwa von einem Mikrocontroller erzeugtes Analogsignal in das zur Leitungsprüfung verwendete Stromsignal umsetzen. Auf diese Weise kann die Simulation der Stromund/oder Leistungsaufnahme des mindestens einen Aktors mit geringem Aufwand und kostengünstig umgesetzt werden.

Gemäß einer vorteilhaften Ausführungsform weist das Ansteuer- und Überwachungsmodul ferner eine Kommunikationseinrichtung, insbesondere eine Busschnittstelle auf. Über diese Busschnittstelle ist das Ansteuer- und Überwachungsmodul mit einer Systemsteuerung kommunikativ verbunden oder verbindbar. Diese Systemsteuerung kann beispielsweise Teil eines Brandschutzsystems sein und über einen Bus Informationen mit Komponenten des Brandschutzsystems austauschen. In einem Beispiel handelt es sich bei der Systemsteuerung um eine Brandmelderzentrale und bei den Teilnehmern um Brandmelder und Aktoren wie Alarmmittel. Datenbusse können in solchen Systemen in verschiedenen Topologien vorliegen, beispielsweise als Stichleitung oder Ringleitung ("Loop"). Die Datenübertragung über den Bus kann gemäß unterschiedlichen Kommunikationsprotokollen erfolgen, beispielsweise gemäß einem TCP/IP-Protokoll oder einem Modbusprotokoll (Modbus RTU, Modbus TCP). Insbesondere Hersteller von Brandmeldern und Brandmeldeanlagen nutzen herstellerspezifische Protokolle zur Kommunikation zwischen den Brandmeldern und einer Brandmelderzentrale. Die Busschnittstelle des Ansteuer- und Überwachungsmoduls ist entsprechend kompatibel mit der Bustopologie und dem verwendeten Kommunikationsprotokoll zu wählen, beispielsweise im Falle eines Modbus-RTU-Protokolls als RS 485-Schnittstelle. Selbstverständlich sind auch andere Busse, Protokolle und Busschnittstellen denkbar. Bevorzugt handelt es sich um eine serielle Schnittstelle wie etwa nach dem RS 485 oder RS 232 Standard oder andere verbreitete Kommunikationsschnittstellen wie Ethernet oder CAN-Bus.

Durch das Vorsehen einer Busschnittstelle in dem Ansteuer- und Überwachungsmodul kann eine zeitgemäße Vernetzung des Moduls mit Steuerungen und Komponenten von Systemen, insbesondere Brandschutzsystemen, realisiert werden und ein Datenaustausch zwischen dem Modul und anderen Netzwerkteilnehmern stattfinden, z.B. die Übertragung der durch die Messeinrichtung ermittelten Werte, die Übertragung von Störungsmeldungen an eine Steuerung oder die Übertragung von an einer Steuerung eingestellten Schwellenwerten an ein oder mehrere Ansteuer- und Überwachungsmodule.

In einer bevorzugten Ausführungsform umfasst das Ansteuer- und Überwachungsmodul ferner eine bevorzugt integrierte Modulsteuerung zur Signal- und/oder Energieversorgung der bzw. zur Kommunikation mit der Ansteuereinrichtung, der Messeinrichtung, der Prüfeinrichtung, der bevorzugt integrierten, optionalen Speichereinrichtung und/oder der optionalen Kommunikationseinrichtung. Die Modulsteuerung dient dazu, wichtige Bestandteile des Ansteuer- und Überwachungsmoduls wie die Ansteuereinrichtung, Messeinrichtung oder Prüfeinrichtung anzusteuern sowie Daten der Messeinrichtung auszuwerten, beispielsweise mit in einer Speichereinrichtung hinterlegten Schwellwerten zu vergleichen. Bei der Modulsteuerung handelt es sich bevorzugt um einen programmierbaren Baustein, beispielsweise um eine programmierbare Logik, einen Mikrocontroller oder Mikroprozessor. Hierdurch ist es möglich, die vorgenannten Steuerungs- und Kommunikationsfunktionen mit einem vergleichsweise kleinen Bauteil zu realisieren, welches in das Ansteuer- und Überwachungsmodul integrierbar ist. Selbstverständlich kann die Steuerungs- und Auswerteschaltung alternativ auch diskret aufgebaut sein.

Gemäß einem weiteren Aspekt betrifft die vorliegende Erfindung ein System, insbesondere Brandschutzsystem, welches mindestens einen Aktor, eine Systemsteuerung zur Versorgung des Aktors mit Signalen, eine Energieversorgungseinrichtung zur Versorgung des Aktors mit elektrischer Energie, und mindestens eine Signal- und/oder Versorgungsleitung aufweist, welche zwischen der Systemsteuerung und/oder der Energieversorgungseinrichtung und dem mindestens einen Aktor verläuft. Dem mindestens einen Aktor ist ein erfindungsgemäßes Ansteuer- und Überwachungsmodul zugeordnet, wobei dieses ausgebildet ist, die mindestens eine Signal- und/oder Versorgungsleitung auf Störung zu überwachen und/oder den mindestens einen Aktor anzusteuern und/oder die Ansteuerung des mindestens einen Aktors zu simulieren.

Bei dem System handelt es sich bevorzugt um ein Brandschutzsystem, beispielsweise um eine Brandvermeidungs-, Brandmelde- oder eine Löschanlage. Eine Brandvermeidungsanlage kann beispielsweise durch Herabsetzung des Sauerstoffgehaltes in einem umschlossenen Bereich, insbesondere mittels Einleitung von sauerstoffreduzierter Luft in den Bereich, die Entzündungsgefahr in dem Bereich reduzieren. Die Brandvermeidungsanlage enthält neben Maschinen zur Erzeugung eines sauerstoffreduzierten Volumenstroms auch eine Steuerung für die geregelte Einleitung der sauerstoffreduzierten Luft. In einem Gefahrenfall, beispielsweise wenn der Sauerstoffgehalt in dem umschlossenen Bereich in einen für Personen schädlichen Wertebereich absinkt, leitet die Steuerung Schutzmaßnahmen ein. Diese betreffen insbesondere die Ansteuerung von Aktoren wie Alarmmitteln oder Ventilen, beispielsweise sogenannten Bereichsventilen, um beispielsweise den Zufluss sauerstoffreduzierter Luft in den umschlossenen Bereich zu ermöglichen, diesen zuverlässig wieder zu stoppen oder auch um im Bedarfsfall eine gesonderte Frischluftzufuhr zur raschen Erhöhung des Sauerstoffgehaltes in dem Bereich umzusetzen.

Eine Brandmeldeanlage umfasst in der Regel mehrere Brandmelder, die kommunikativ mit einer übergeordneten Systemsteuerung bzw. Brandmelderzentrale verbunden sind. Detektiert einer der Brandmelder einen Brand, beispielsweise anhand einer Rauch-, Flammen- oder Wärmeentwicklung, meldet er diesen an die Brandmelderzentrale. Diese reagiert auf die Meldung beispielsweise durch Ansteuern von Aktoren wie Alarmierungsmitteln und durch Absetzen von Notrufen.

Eine Löschanlage umfasst im Allgemeinen neben einem Löschmittelreservoir und einem Leitungsund Düsensystem zum Verteilen des Löschmittels ebenfalls eine Systemsteuerung, auch Löschzentrale genannt. Bei der Löschanlage kann es sich beispielsweise um eine Gaslöschanlage handeln, die den Brand durch Einleitung einer hohen Gasmenge (Inertgas oder chemische Gasmischung) erstickt. Auf Erhalt eines Gefahrensignals, z.B. eine Brandmeldung, löst die Systemsteuerung eine Löschung aus. Hierzu steuert sie Alarmmittel wie Hupen und Blitzlampen an, um eine Evakuierung zu veranlassen, und betätigt weitere Aktoren wie Bereichs- oder Flaschenventile, um die koordinierte Einleitung von Löschmittel zu steuern.

Alle drei vorgenannten Arten von Brandschutzsystemen haben die Gemeinsamkeit einer Systemsteuerung zur Aktivierung unterschiedlicher Aktoren. Bei den Aktoren handelt es sich insbesondere um Alarmmittel wie Hupen, Blitzlampen und Leuchtfelder, aber auch um Stellmittel wie Ventile, Motoren oder Türschalter. Um die Aktoren mit Energie und Signalen zu versorgen, sind häufig Signal- und Versorgungsleitungen, beispielsweise in Form von Zweidraht- oder Mehrdrahtleitungen, zwischen der Systemsteuerung und den Aktoren vorgesehen. Dabei sind verschiedenste Konfigurationen denkbar: Beispielsweise kann die Systemsteuerung eine integrierte Energieversorgungseinrichtung umfassen oder mit einer gesonderten zentralen Energieversorgungseinrichtung in einem Gehäuse zusammengefasst sein. In diesen Fällen können jeweils eine Signal- und eine Energieversorgungsleitung zu den Aktoren vorgesehen sein. Alternativ können die Signal- und Energieversorgung über eine gemeinsame Leitung erfolgen oder in einem gemeinsamen Kabel zusammengefasst sein. In einer weiteren Alternative können mehrere dezentrale Energieversorgungseinrichtungen in dem System vorgesehen sein, die einerseits die Systemsteuerung, andererseits die Aktoren jeweils über eigene Energieversorgungsleitungen versorgen.

Bei allen Varianten sind die Signal- und/oder Energieversorgungsleitungen gemäß den oben genannten Anforderungen aus Normen und Richtlinien auf einen kritisch hohen oder kritisch niedrigen Leitungswiderstand, bei dem eine Ansteuerungsfunktion nicht mehr zuverlässig gewährleistet werden kann, zu überwachen.

Erfindungsgemäß ist dem mindestens einen Aktor des Systems ein Ansteuer- und Überwachungsmodul zugeordnet, das die bedarfsweise Ansteuerung des Aktors sowie die Überwachung der Signal- und/oder Versorgungsleitung auf unzulässig hohen oder niedrigen Leitungswiderstand durchführt. Hierzu umfasst das Ansteuer- und Überwachungsmodul vorzugsweise eine Ansteuereinrichtung zum Ansteuern des mindestens einen Aktors, eine Messeinrichtung zum Ermitteln einer Strom- und/oder Leistungsaufnahme des mindestens einen Aktors und zum Ermitteln einer an dem Ansteuer- und Überwachungsmodul und/oder einer an dem Aktor anliegenden Spannung, sowie eine Prüfeinrichtung zum Simulieren einer Strom- und/oder Leistungsaufnahme des mindestens einen Aktors. Dabei ist das Ansteuer- und Überwachungsmodul vorzugsweise ausgebildet, eine Störung der mindestens einen Signal- und/oder Versorgungsleitung zu dem Ansteuer- und Überwachungsmodul und/oder zu dem mindestens einen dem Ansteuer- und Überwachungsmodul zugeordneten Aktors zu erkennen, wenn bei einer von der Prüfeinrichtung des Ansteuer- und Überwachungsmoduls durchgeführten Simulation eine an dem Ansteuer- und Überwachungsmodul und/oder eine an dem Aktor anliegende Spannung einen vorab festgelegten oberen Spannungsschwellwert überschreitet oder einen vorab festgelegten unteren Spannungsschwellwert unterschreitet.

Insbesondere bei wiederholtem oder aufeinanderfolgenden Erkennen einer Störung der Signalund/oder Versorgungsleitung durch das Ansteuer- und Überwachungsmodul setzt dieses eine Störungsmeldung an die Systemsteuerung ab, beispielsweise über eine Kommunikationsschnittstelle des Ansteuer- und Überwachungsmoduls. Die Systemsteuerung ergreift bei Erhalt einer solchen Störungsmeldung geeignete Maßnahmen, beispielsweise stellt sie die Störungsmeldung auf einer zentralen Anzeige, beispielsweise einem Bedienpanel des Systems dar oder sendet eine Störungsnachricht an eine ständig besetzte Stelle.

Alternativ oder zusätzlich ist die Systemsteuerung des Systems zur Auswertung der gemessenen elektrischen Größen des Ansteuer- und Überwachungsmoduls sowie zum Vergleich der Messwerte mit hinterlegten Schwellwerten und somit zur Erkennung einer Störung der Signal- und/oder Versorgungsleitung ausgebildet. Hierbei stellt die Systemsteuerung eine Störung fest, wenn bei einer von der Prüfeinrichtung des Ansteuer- und Überwachungsmoduls durchgeführten Simulation eine an dem Ansteuer- und Überwachungsmodul und/oder eine an dem Aktor anliegende Spannung einen vorab festgelegten oberen Spannungsschwellwert überschreitet oder einen vorab festgelegten unteren Spannungsschwellwert unterschreitet. In dieser Variante ermittelt die Messeinrichtung des Ansteuer- und Überwachungsmoduls die an dem Ansteuer- und Überwachungsmodul bzw. an dem mindestens einen Aktor anliegende Spannung und übermittelt die Messwerte beispielsweise über die Signal- und/oder Versorgungsleitung, insbesondere über einen mittels einer Busschnittstelle angeschlossenen Bus, an die Systemsteuerung. Diese vergleicht die erhaltenen Messwerte mit in der Systemsteuerung gespeicherten Schwellwerten und erkennt eine Störung, wenn ein oder mehrere Spannungsmesswerte einen der Schwellwerte unter- bzw. überschreiten. Analog können auch weitere Schwellwerte wie Strom- oder Leistungsschwellwerte in der Systemsteuerung hinterlegt sein, zudem können die in einem Anlernmodus ermittelten Anlernwerte eines Ansteuer- und Überwachungsmoduls an die Systemsteuerung übertragen und dort mit entsprechenden Schwellwerten verglichen werden. Ebenso können umgekehrt auch Ansteuersignale von der Systemsteuerung an die Ansteuer-, Mess- und/oder Prüfeinrichtung des Ansteuer- und Überwachungsmoduls übermittelt werden. Bei Übertragung einzelner oder alle Steuerungs- und/oder Auswerteaufgaben von der Modulsteuerung des Ansteuer- und Überwachungsmoduls auf die Systemsteuerung kann das Ansteuer- und Überwachungsmodul kleiner dimensioniert und somit kostengünstiger gestaltet werden.

Gemäß bevorzugten Ausführungsformen ist die Ansteuereinrichtung ausgebildet, in einem Anlernmodus und/oder Ansteuermodus den mindestens einen Aktor anzusteuern. Vorteilhafterweise ist die Messeinrichtung ausgebildet, in dem Anlernmodus und/oder Ansteuermodus die Stromund/oder Leistungsaufnahme des mindestens einen angesteuerten Aktors zu ermitteln. Die Prüfeinrichtung kann ausgebildet sein, in einem Überwachungsmodus die ermittelte Strom- und/oder Leistungsaufnahme des mindestens einen Aktors zu simulieren. In dem Überwachungsmodus ermittelt die Messeinrichtung bevorzugterweise die an dem Ansteuer- und Überwachungsmodul und/oder dem mindestens einen Aktor anliegende Spannung.

Grundsätzlich ist es vorteilhaft, wenn die Systemsteuerung des Systems ausgebildet ist, vorzugsweise bei oder unmittelbar nach einer anfänglichen Inbetriebnahme des Systems, nach einer Wartung oder bedarfsweise das dem mindestens einen Aktor zugeordnete Ansteuer- und Überwachungsmodulin einen Anlernmodus zu überführen, in welchem der mindestens eine Aktor angesteuert und die Strom- und/oder Leistungsaufnahme des mindestens einen Aktors ermittelt wird. Bei der Inbetriebnahme des Systems kann mit einer hohen Wahrscheinlichkeit von intakten Signalund Versorgungsleitungen sowie intakten Aktoren ausgegangen werden, sodass von einem bei den Messungen korrekt wiedergegebenen Anfangszustand des Systems und somit von für die weitere Leitungsüberwachung geeigneten Anlernwerten ausgegangen werden kann. Selbstverständlich ist das Ansteuer- und Überwachungsmodul jedoch auch zu einem späteren Zeitpunkt in den Anlernmodus überführbar, beispielsweise um eine veränderte Gesamtlast des Systems durch nachträglich hinzugefügte oder entfernte Aktoren bei der Überwachung zu berücksichtigen.

Die Erfindung erweist sich als besonders vorteilhaft, wenn das System in einer Variante mehrere Ansteuer- und Überwachungsmodule umfasst und entweder alle Module des Systems oder alle Module an einer spezifischen Energie- und/oder Signalversorgungsleitung gleichzeitig durch die Systemsteuerung des Systems in den Anlernmodus überführbar sind. Dadurch wird die exakte und vollständige bzw. maximale Strom- und/oder Leistungsaufnahme des Systems bzw. der Leitung mit allen betroffenen Ansteuer- und Überwachungsmodulen im Anlernmodus gemessen und ausgewertet. Da beispielsweise in einem Alarmfall alle Alarmierungsmittel gleichzeitig einzuschalten sind und die hierzu notwendige elektrische Energie an allen verteilten Alarmierungsmitteln gleichzeitig in ausreichender Höhe zur Verfügung stehen muss, kann diese hohe Belastung mit dem erfindungsgemäßen System in einem Anlernmodus nachgestellt und die dabei gemessenen Werte können einer nachfolgenden Leitungsüberwachung zugrunde gelegt werden.

In einer bevorzugten Ausführungsform des erfindungsgemäßen Systems wird in dem Anlernmodus die an dem Ansteuer- und Überwachungsmodul und/oder dem mindestens einen Aktor anliegende Spannung ermittelt. Diese Systemvariante erhöht die Zuverlässigkeit der Leitungsüberwachung, da somit während des Anlernens der aktorspezifischen Strom- und Leistungskenngrößen eine zusätzliche Prüfung der zur Verfügung stehenden Spannung durchführbar ist und eine für das System ungeeignete Überlänge von Leitungen oder ungeeignete Überanzahl von Aktoren sofort festgestellt werden kann

In einer weiteren, besonders vorteilhaften Variante des erfindungsgemäßen Systems ist die Systemsteuerung ausgebildet, vorzugsweise unmittelbar nach einem Anlernmodus das dem mindestens einen Aktor zugeordnete Ansteuer- und Überwachungsmodul in einen Vorprüfmodus zu überführen, in welchem das dem mindestens einen Aktor zugeordnete Ansteuer- und Überwachungsmodul die Strom- und/oder Leistungsaufnahme des mindestens einen Aktors simuliert, die an dem Ansteuer- und Überwachungsmodul und/oder dem mindestens einen Aktor anliegende Spannung ermittelt wird und bei Überschreiten eines vorab festgelegten oberen Spannungsschwellwerts oder bei Unterschreiten eines vorab festgelegten unteren Spannungsschwellwertes die simulierte Strom- und/oder Leistungsaufnahme manuell oder automatisch nachgeregelt wird. Bei dieser Ausführungsform wird also zusätzlich überprüft, ob die angelernten bzw. die zur Simulation verwendeten Werte korrekt ermittelt wurden oder ob beispielsweise ein Messfehler oder ein Berechnungsfehler, etwa bei der Ermittlung des Effektivwertes, vorliegt. Hierbei wird davon ausgegangen, dass sich das System während eines Anlernmodus in einem intakten Zustand befindet, also insbesondere kein Defekt der Signal- und Energieversorgungsleitungen oder der Aktoren vorliegt. Wird dennoch ein zu hoher oder zu niedriger Spannungswert ermittelt, kann die simulierte Strom- und/oder Leistungsaufnahme nach- bzw. feinjustiert, also nachgeregelt werden. Dies erfolgt bevorzugt automatisch, beispielsweise programmbasiert mittels einer Modulsteuerung in Form eines Mikrocontrollers.Alternativ kann die Nachregelung auch manuell vorgenommen werden, beispielsweise direkt an der Modulsteuerung oder indirekt über die Systemsteuerung. Hierzu ergeht bei Messung eines zu hohen oder zu niedrigen Spannungswertes eine Aufforderung zur manuellen Nachregelung seitens der Modul- oder Systemsteuerung an einen eingewiesenen Benutzer.

Weiterhin ist es von Vorteil, wenn die Systemsteuerung ausgebildet ist, das dem mindestens einen Aktor zugeordnete Ansteuer- und Überwachungsmodul insbesondere zyklisch in einen Überwachungsmodus zu überführen. In dem Überwachungsmodus simuliert das dem mindestens einen Aktor zugeordnete Ansteuer- und Überwachungsmodul die Strom- und/oder Leistungsaufnahme des mindestens einen Aktors und ermittelt die an dem Ansteuer- und Überwachungsmodul und/oder dem mindestens einen Aktor anliegende Spannung. Hierbei ist das Ansteuer- und Überwachungsmodul ausgebildet, eine Störung der mindestens einen Signalund/oder Versorgungsleitung zu erkennen, wenn bei einer Simulation eine an dem Ansteuer- und Überwachungsmodul und/oder dem Aktor anliegende Spannung einen vorab festgelegten oberen Spannungsschwellwert überschreitet oder einen vorab festgelegten unteren Spannungsschwellwert unterschreitet. Mit anderen Worten koordiniert die Systemsteuerung den jeweiligen Zeitpunkt der Simulation durch die Prüfeinrichtung, wobei diese bevorzugt in regelmäßigen Abständen, also zyklisch wiederholt wird. Beispielsweise überführt die Systemsteuerung das Ansteuer- und Überwachungsmodul alle 10 Sekunden in den Überwachungsmodus. Selbstverständlich kann der Überwachungsmodus je nach Anforderung auch in kürzeren oder längeren Zeitabständen eingenommen werden. Es ist jedoch alternativ oder zusätzlich auch denkbar, dass die Systemsteuerung das Ansteuer- und Überwachungsmodul aufgrund bestimmter Ereignisse in den Überwachungsmodus überführt, beispielsweise im Anschluss an einen Stromausfall.

Die Erfindung erweist sich als besonders vorteilhaft, wenn das System in einer Variante mehrere Ansteuer- und Überwachungsmodule umfasst und entweder alle Module des Systems oder alle Module an einer spezifischen Energie- und/oder Signalversorgungsleitung gleichzeitig durch die Systemsteuerung des Systems in den Überwachungsmodus überführbar sind. Dadurch wird die vollständige bzw. maximale Strom- und/oder Leistungsaufnahme des Systems bzw. der Leitung mit allen betroffenen Ansteuer- und Überwachungsmodulen im Überwachungsmodus simuliert und ausgewertet. Sind im Alarmfall beispielsweise alle Alarmierungsmittel gleichzeitig einzuschalten, wird durch das erfindungsgemäße System mit dem beschriebenen Überwachungsmodus zuverlässig noch vor einem solchen Alarmfall erkannt, ob die hierzu notwendige elektrische Energie in ausreichender Höhe an allen in dem System verteilten Aktoren bzw. Alarmmitteln zur Verfügung steht.

Gemäß bevorzugten Ausführungsformen des erfindungsgemäßen Systems ist die Systemsteuerung ausgebildet, das dem mindestens einen Aktor zugeordnete Ansteuer- und Überwachungsmodul in einen Ansteuermodus zu überführen, in welchem das Ansteuer- und Überwachungsmodul den mindestens einen Aktor ansteuert. Die Überführung in einen Ansteuermodus kann beispielsweise durch eine Brandmeldung bei einem als Brandmeldeanlage ausgeführten System, durch eine Unterschreitung eines unteren Sauerstoffschwellwertes, was einen Bedarf an sauerstoffreduzierter Luftzufuhr oder einen Warn- und Evakuierungsbedarf bedeuten kann, bei einem als Brandvermeidungsanlage ausgeführten System oder durch ein Löschauslösesignal bei einem als Löschanlage ausgeführten System ausgelöst werden. In dem Ansteuermodus schaltet das Ansteuerund Überwachungsmodul die an dem Modul anliegende Energieversorgung zu dem mindestens einen Aktor durch, sodass dieser die gewünschte Aktorleistung erzeugt, beispielsweise ein Ventil öffnet oder als aktivierte Blitzleuchte, Hupe oder Leuchtfeld seine Alarmierungsfunktion erfüllt. Diese Ausführungsform zeigt besonders deutlich die bevorzugte Doppelfunktion des Ansteuer- und Überwachungsmoduls, das einerseits die zuverlässige Ansteuerung der in dem System befindlichen Aktoren und andererseits die verlässliche Überwachung der Energieversorgungsleitungen zu den Aktoren ermöglicht.

In einer Ausführungsform des erfindungsgemäßen Systems sind mindestens zwei Ansteuer- und Überwachungsmodule mit jeweils mindestens einem Aktor in dem System vorgesehen. Hierbei ist die Systemsteuerung ausgebildet, bei einem von einer Messeinrichtung mindestens eines der Ansteuer- und Überwachungsmodule festgestellten Überschreiten oder Unterschreiten eines oberen oder unteren Strom-, Leistungs- und/oder Spannungsschwellwerts eine Störung der mindestens einen Signal- und/oder Versorgungsleitung festzustellen. Bevorzugt kann die Systemsteuerung zudem eine Lokalisierung der Störung in dem System durchführen.

Diese Variante bildet den praxisnahen Fall ab, dass das beispielsweise als Brandvermeidungsanlage, Brandmeldeanlage oder Löschanlage ausgeführte System über mehr als einen Aktor, also beispielsweise mehr als eine Hupe, Blitzleuchte oder Leuchtfeld bzw. mehr als ein Ventil oder Türschalter verfügt. Den mehreren Aktoren ist beispielsweise einzeln oder paarweise ein Ansteuer- und Überwachungsmodul zugeordnet. Wird mithilfe der Ansteuer- und Überwachungsmodule eine Störung der Signal- und/oder Versorgungsleitung festgestellt, kann die Systemsteuerung beispielsweise durch serielles Abfragen bzw. Ansteuern der Ansteuer- und Überwachungsmodule bzw. ihrer zugeordneten Aktoren oder beispielsweise durch systematisches Auswerten der erhaltenen Störungsmeldungen der Ansteuer- und Überwachungsmodule eine Lokalisierung vornehmen. Bei einer solchen Lokalisierung kann die Systemsteuerung beispielsweise feststellen, auf welchem Leitungsabschnitt bzw. zwischen welchen Ansteuer- und Überwachungsmodulen ein Defekt der Signal- und/oder Versorgungsleitung vorliegt oder welcher Aktor einen Kurzschluss verursacht.

Die vorliegende Erfindung betrifft ferner ein Verfahren zum Betreiben eines Ansteuer- und Überwachungsmoduls zum Ansteuern mindestens eines dem Ansteuer- und Überwachungsmodul zugeordnerten Aktors und zum Überwachen mindestens einer Signal- und/oder Versorgungsleitung zu dem Ansteuer- und Überwachungsmodul und/oder zu dem mindestens einen Aktor. Das Verfahren weist erfindungsgemäß die folgenden Verfahrensschritte auf:
▪ Ansteuern des mindestens einen Aktors und Ermitteln einer Strom- und/oder Leistungsaufnahme des mindestens einen Aktors in einem Anlernmodus;
▪ Simulieren der im Anlernmodus ermittelten Strom- und/oder Leistungsaufnahme des mindestens einen Aktors und Ermitteln der an dem Ansteuer- und Überwachungsmodul und/oder an dem Aktor anliegenden Spannung in einem bevorzugt zyklisch eingeleiteten Überwachungsmodus;
▪ Ansteuern des mindestens einen Aktors in einem bedarfsweise eingeleiteten Ansteuermodus.

Gemäß dem erfindungsgemäßen Verfahren ist es erstmals möglich, mit einem kombinierten Ansteuer- und Überwachungsmodul einerseits eine verlässliche Ansteuerung mindestens eines Aktors und andererseits eine besonders zuverlässige Überwachung von Signal- und/oder Versorgungsleitung zu dem Modul bzw. zu dem mindestens einen Aktor durchführen zu können. Hierzu sind nur wenige Verfahrensschritte notwendig, nämlich ein initiales Ansteuern des mindestens einen Aktors, bevorzugt vieler Aktoren gleichzeitig, ein Messen seiner/ihrer Strom- und/oder Leistungsaufnahme sowie anschließendes Simulieren der gemessenen Strom- und/oder Leistungswerte und Ermitteln an dem Ansteuer- und Überwachungsmodul bzw. an dem Aktor anliegenden Spannung für eine realistische Leitungsprüfung. Selbstverständlich kann der mindestens eine Aktor jederzeit bedarfsweise real angesteuert werden, um seine Aktorfunktion zu erfüllen, beispielsweise als Alarmierungsmittel oder Stellmittel.

In einer besonders vorteilhaften Variante ist das Verfahren so ausgelegt, dass die Verfahrensschritte für mehrere Ansteuer- und Überwachungsmodule, beispielsweise mehrere oder alle Ansteuer- und Überwachungsmodule eines Brandschutzsystems, gleichzeitig durchführbar sind. Dies bedeutet, dass für mehrere Ansteuer- und Überwachungsmodule gleichzeitig ein Ansteuern in einem Anlernmodus und/oder gleichzeitig ein Simulieren in einem Überwachungsmodus und/oder gleichzeitig ein Ansteuern in einem Ansteuermodus erfolgt. Dadurch kann gewährleistet werden, dass die Überwachung der mindestens einen Signal- und/oder Versorgungsleitung zu den Ansteuerund Überwachungsmodulen mit den exakten und vollständigen bzw. maximalen Strom- und/oder Leistungsaufnahmewerten erfolgt.

In einer bevorzugten Ausführungsform des Verfahrens sind dem Ansteuer- und Überwachungsmodul mindestens zwei Aktoren zugeordnet, wobei für einen Aktor der Ansteuermodus und für den mindestens einen weiteren Aktor der Überwachungsmodus oder wobei für einen Aktor der Überwachungsmodus und für den mindestens einen weiteren Aktor der Ansteuermodus gleichzeitig durchführbar sind. Die mindestens zwei Aktoren sind hierbei parallel geschaltet. Hierdurch wird es erstmalig möglich, während eines Ansteuerfalls weiterhin eine Leitungsprüfung für weitere Aktoren vornehmen zu können, indem die zusätzliche Strom- und/oder Leistungsaufnahme eines nicht angesteuerten Aktors zusätzlich zu einem angesteuerten Aktor simuliert wird. Dieser Vorteil wird insbesondere dann deutlich, wenn es sich bei einem Aktor um ein Leuchtfeld handelt, da Leuchtfelder mitunter dauerhaft mit elektrischer Energie versorgt werden (z.B. um permanent einen Hinweis auf einen sauerstoffreduzierten Bereich anzuzeigen). In diesem Fall kann die Leitungsüberwachung für weitere Aktoren, die an demselben Ansteuer- und Überwachungsmodul angeschlossen sind, zuverlässig gewährleistet werden.

Nachfolgend werden exemplarische Ausführungsformen des erfindungsgemäßen Ansteuer- und Überwachungsmoduls anhand der beiliegenden Zeichnungen näher beschrieben.

Es zeigen:
- FIG. 1: schematisch eine exemplarische Ausführungsform eines Ansteuer- und Überwachungsmoduls gemäß einer exemplarischen Ausführungsform der Erfindung;
- FIG. 2a: schematisch eine erste exemplarische Ausführungsform des erfindungsgemäßen Systems mit mehreren Ansteuer- und Überwachungsmodulen gemäß der Erfindung;
- FIG. 2b: schematisch eine zweite exemplarische Ausführungsform des erfindungsgemäßen Systems mit mehreren Ansteuer- und Überwachungsmodulen gemäß der Erfindung;
- FIG. 3a-e: Beispiele für den zeitlichen Verlauf der Stromaufnahme von unterschiedlichen Aktoren in deren jeweils eingeschalteten Zustand; und
- FIG. 4: schematisch ein Flussdiagramm zum Erläutern einer exemplarischen Ausführungsform des erfindungsgemäßen Verfahrens.

Das in den Zeichnungen schematisch dargestellte Ansteuer- und Überwachungsmodul 1; 1a, 1b dient zum Ansteuern von Aktoren 2a, 2b, wie beispielsweise Alarmierungsmitteln oder Stellmitteln, sowie zum Überwachen der zu diesen Aktoren 2a, 2b führenden Signal- und/oder Versorgungsleitungen 3, 4. Das Ansteuer- und Überwachungsmodul 1; 1a, 1b gemäß den exemplarischen Ausführungsformen überwacht die Signal- und/oder Versorgungsleitungen 3, 4 gemäß der Norm EN 54-13 2005 auf einen erhöhten oder reduzierten Leitungswiderstand, bei dem eine Ansteuerfunktion nicht mehr zuverlässig gewährleistet werden kann. Es ist bevorzugt in unmittelbarer Nähe der Aktoren 2a, 2b angeordnet und beispielsweise durch wenige Zentimeter kurze Ansteuerungsleitungen oder durch direkte Steckverbinder mit den Aktoren 2a, 2b verbunden. Das Ansteuer- und Überwachungsmodul 1; 1a, 1b ist derart ausgebildet, dass es eine Störung meldet, wenn bzw. bevor eine angeschlossene Signal- und/oder Versorgungsleitung die für den entsprechenden Aktor 2a, 2b vorgesehene Ansteuerfunktion aufgrund eines unzulässig hohen oder niedrigen Leitungswiderstandes nicht mehr ausführen kann.

Gemäß exemplarischen Ausführungsformen der vorliegenden Erfindung wird für jeden Aktor 2a, 2b ein Ansteuer- und Überwachungsmodul 1; 1a, 1b benötigt, welches die Signal- und/oder Versorgungsleitung 3, 4 zu diesem Aktor 2a, 2b bzw. zu dem Ansteuer- und Überwachungsmodul 1; 1a, 1b überwacht. Insbesondere für Ventile kann es aufgrund der komplexen Strom- und Leistungsaufnahme sinnvoll sein, diesen jeweils ein eigenes Ansteuer- und Überwachungsmodul 1; 1a, 1b zuzuordnen. Gemäß anderen Ausführungsformen können jedem Ansteuer- und Überwachungsmodul 1; 1a, 1b zwei oder mehr Aktoren 2a, 2b zugeordnet sein, wobei dann dieses Ansteuer- und Überwachungsmodul 1; 1a, 1b die Signal- und/oder Versorgungsleitungen 3, 4 der Aktoren 2a, 2b entsprechend überwacht. Beispielsweise kann für Alarmierungsmittelkombinationen, etwa aus Blitzlampe und Hupe, oder etwa auch für Leuchtfeldkombinationen wie auf der Innen- und der Außenseite einer Tür, schon aus Kostengründen ein gemeinsames Ansteuer- und Überwachungsmodul 1; 1a, 1b besonders geeignet sein.

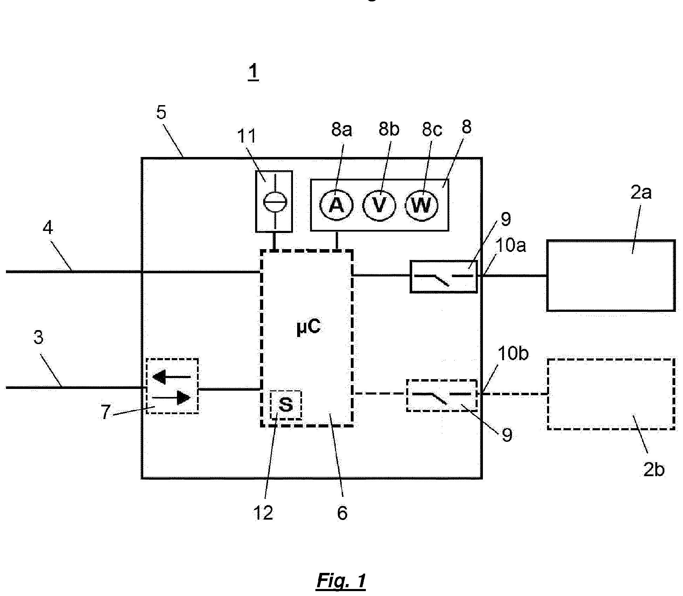

FIG. 1 zeigt das schematisch dargestellte Ansteuer- und Überwachungsmodul mit seinen Hauptkomponenten (in durchgezogenen Linien dargestellt) sowie weiteren vorteilhaften Komponenten (in gestrichelten Linien dargestellt). Das in FIG. 1 schematisch dargestellte Ansteuerund Überwachungsmodul 1 ist einem Aktor 2a, beispielsweise einer Hupe, sowie optional einem weiteren Aktor 2b, beispielsweise einer Blitzlampe, zugeordnet. Das Ansteuer- und Überwachungsmodul 1 dient der Überwachung der Signalleitung 3 und/oder der Versorgungsleitung 4 auf einen erhöhten bzw. reduzierten Leitungswiderstand, bei dem eine Ansteuerfunktion nicht mehr zuverlässig gewährleistet werden kann. Es dient zudem dem Ansteuern der Aktoren 2a, 2b. Das Ansteuer- und Überwachungsmodul 1 enthält eine oder mehrere Ansteuereinrichtungen 9, hier in Form von Schaltern dargestellt, die die über eine Versorgungsleitung 4 bereitgestellte elektrische Energie in einem Anlernmodus oder bedarfsweise in einem Ansteuermodus über Aktorausgänge 10a, 10b zu den Aktoren 2a, 2b durchschaltet und diese somit aktiviert. Das Ansteuer- und Überwachungsmodul 1 umfasst ferner eine beispielsweise als diskrete Schaltung aufgebaute Messeinrichtung 8 zur Messung elektrischer Größen wie Strom, Spannung und Leistung, hier symbolhaft durch ein Amperemeter 8a, ein Voltmeter 8b und ein Wattmeter 8c dargestellt. Die Messeinrichtung 8 dient vorrangig zum Ermitteln einer Strom- und/oder Leistungsaufnahme des mindestens einen Aktors 2a, 2b und zum Ermitteln einer an dem Ansteuer- und Überwachungsmodul 1 und/oder dem Aktor 2a, 2b anliegenden Spannung. Weiterhin umfasst das Ansteuer- und Überwachungsmodul 1 eine Prüfeinrichtung 11 zur Simulation einer zuvor ermittelten Stromund/oder Leistungsaufnahme der angeschlossenen Aktoren 2a, 2b. In dem gezeigten Beispiel ist die Prüfeinrichtung 11 als Stromsenke ausgebildet.

Demnach umfasst das erfindungsgemäße Ansteuer- und Überwachungsmodul 1 gemäß FIG. 1 zumindest eine Ansteuereinrichtung 9 zum Ansteuern der Aktoren 2a, 2b, eine Messeinrichtung 8 zum Ermitteln einer Strom- und/oder Leistungsaufnahme des mindestens einen Aktors 2a, 2b und zum Ermitteln einer an dem Ansteuer- und Überwachungsmodul 1 und/oder einer an dem Aktor 2a, 2b anliegenden Spannung, sowie eine Prüfeinrichtung 11 zum Simulieren einer Strom- und/oder Leistungsaufnahme des mindestens einen Aktors 2a, 2b. Dabei ist das Ansteuer- und Überwachungsmodul 1 ausgebildet, eine Störung der mindestens einen Signal- und/oder Versorgungsleitung 3, 4 zu dem Ansteuer- und Überwachungsmodul 1 und/oder zu den Aktoren 2a, 2b zu erkennen, wenn bei einer von der Prüfeinrichtung 11 des Ansteuer- und Überwachungsmoduls 1 durchgeführten Simulation eine an dem Ansteuer- und Überwachungsmodul 1 und/oder eine an den Aktoren 2a, 2b anliegende Spannung einen vorab festgelegten oberen Spannungsschwellwert überschreitet oder einen vorab festgelegten unteren Spannungsschwellwert unterschreitet.

Das gezeigte Ansteuer- und Überwachungsmodul 1 erkennt zudem eine Störung der mindestens einen Signal- und/oder Versorgungsleitung 3, 4, wenn bei einem Ansteuern des mindestens einen Aktors 2a, 2b eine Stromaufnahme des mindestens einen Aktors 2a, 2b einen vorab festgelegten oberen Stromschwellwert überschreitet oder einen vorab festgelegten unteren Stromschwellwert unterschreitet und/oder wenn eine Leistungsaufnahme des mindestens einen Aktors 2a, 2b einen vorab festgelegten oberen Leistungsschwellwert überschreitet oder einen vorab festgelegten unteren Leistungsschwellwert unterschreitet und/oder wenn eine an dem Ansteuer- und Überwachungsmodul 1 und/oder dem Aktor 2a, 2b anliegende Spannung einen vorab festgelegten oberen Spannungsschwellwert überschreitet oder einen vorab festgelegten unteren Spannungsschwellwert unterschreitet.

Bevorzugt erzeugt das Ansteuer- und Überwachungsmodul 1 eine Fehler- bzw. Störungsmeldung, wenn dieses wiederholt und insbesondere aufeinanderfolgend eine Störung der Signal- und/oder Versorgungsleitung 3, 4 erkennt.

Das Ansteuer- und Überwachungsmodul 1 umfasst vorzugweise eine Kommunikationseinrichtung 7, die beispielsweise als Busschnittstelle ausgeführt sein kann. Es handelt sich dann bei der Signalleitung 3 um eine Busleitung, beispielsweise einen Modbus. Über die Kommunikationseinrichtung 7 und die Signalleitung 3 bzw. Busleitung kann das Ansteuer- und Überwachungsmodul 1 mit Komponenten eines in FIG. 1 nicht weiter gezeigten Systems, beispielsweise mit Systemsteuerungen einer Brandmelde- oder Brandvermeidungsanlage oder einer Löschanlage kommunizieren.

Für die Ansteuerung der verschiedenen Komponenten des Ansteuer- und Überwachungsmoduls 1, also für die Energieversorgung und Kommunikation mit diesen sowie etwa für die Auswertung von Messdaten, beispielsweise für den Vergleich von Messwerten mit Schwellwerten, verfügt das Ansteuer- und Überwachungsmodul 1 über eine Modulsteuerung 6, insbesondere einen Mikrocontroller. Dieser verfügt in bevorzugter Weise über einen internen Speicher 12, in welchem beispielsweise ein Programm für die verschiedenen Steuerungsabläufe und für die Signal- und Datenauswertung hinterlegt ist. Auch können beispielsweise die für die erfindungsgemäße Leitungsüberwachung erforderlichen Schwellwerte in dem Speicher 12 hinterlegt sein. Bei einer optionalen Auswahl- oder Konfigurationsmöglichkeit der Schwellwerte können ferner beispielsweise DIP-Schalter zur manuellen Auswahl bzw. Konfiguration vorgesehen sein.

Das Ansteuer- und Überwachungsmodul 1 ist in FIG. 1 als Kompaktmodul mit einem Gehäuse 5 ausgeführt, wobei an dem Kompaktmodul Anschlüsse für die Signalleitung 3 und die Versorgungsleitung 4 sowie für Aktoren 2a, 2b vorgesehen sind.

Die Ansteuereinrichtung 9 des in FIG. 1 gezeigten Ansteuer- und Überwachungsmoduls 1 ist ausgebildet, in einem Anlernmodus und/oder Ansteuermodus die Aktoren 2a, 2b anzusteuern. Zudem ist die Messeinrichtung 8 ausgebildet, in dem Anlernmodus und/oder Ansteuermodus die Strom- und/oder Leistungsaufnahme der Aktoren 2a, 2b zu ermitteln. Die Prüfeinrichtung 11 dient dazu, in einem Überwachungsmodus die ermittelte Strom- und/oder Leistungsaufnahme der Aktoren 2a, 2b zu simulieren. In dem Überwachungsmodus ermittelt die Messeinrichtung 8 die an dem Ansteuer- und Überwachungsmodul 1 und/oder den Aktoren 2a, 2b anliegende Spannung.

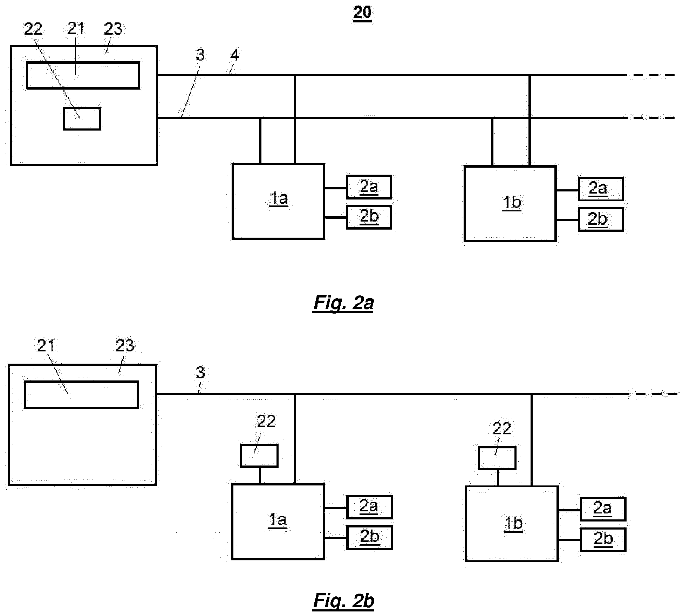

In FIG. 2a ist schematisch eine erste exemplarische Ausführungsform des erfindungsgemäßen Systems 20 dargestellt. Bei diesem System 20 handelt es sich beispielsweise um ein Brandschutzsystem in Form einer Brandmeldeanlage, Brandvermeidungsanlage oder Löschanlage.

Das System 20 weist eine in einem Gehäuse 23 zusammengefasste Systemsteuerung 21 und Energieversorgung 22 auf. Über in FIG. 2a getrennt ausgeführte Signalleitungen 3 und Versorgungsleitungen 4 werden weitere Komponenten des Systems 20 wie beispielsweise Ansteuerund Überwachungsmodule 1a, 1b mit angeschlossenen Aktoren 2a, 2b mit Daten und Energie versorgt. Die Figuren 2a, 2b zeigen die Verbindung zwischen der Systemsteuerung 21 und den weiteren Systemkomponenten als Stichleitung. Selbstverständlich sind hier auch andere Topologien denkbar, beispielsweise eine Ringstruktur, bei der die Signal- und Versorgungsleitungen 3, 4 wieder zu dem Gehäuse 23 mit der Systemsteuerung 21 zurückführen. Auch können mehrere Stich- oder Ringleitungen als Signal- und Versorgungsleitungen (3, 4) in dem System (20) vorgesehen sein.

Vorzugsweise enthält das System 20 zwei oder mehr Ansteuer- und Überwachungsmodule 1a, 1b sowie mehrere Aktoren 2a, 2b. Das gezeigte System 20 ist beispielsweise als Brandvermeidungsanlage ausgestaltet, sodass es sich bei den Aktoren 2a, 2b des Systems 20 beispielsweise einerseits um Alarmmittel wie Hupen, Blitzlampen und Leuchtfelder sowie andererseits um Ventile, insbesondere Bereichsventile handelt.

Die bei dem System 20 zum Einsatz kommenden Ansteuer- und Überwachungsmodule 1a, 1b entsprechen in struktureller und funktioneller Hinsicht dem zuvor unter Bezugnahme auf die Darstellung in FIG. 1 beschriebenen Modul 1. Zur Vermeidung einer Wiederholung wird daher auf die vorherigen Ausführungen verwiesen.

Mit den einzelnen Ansteuer- und Überwachungsmodulen 1a, 1b ist es bei dem erfindungsgemäßen System 20 möglich, eine entsprechende Störung der Signal- und Versorgungsleitungen 3, 4 zu erkennen. Aufgrund der parallelen Anordnung der Ansteuer- und Überwachungsmodule 1a, 1b an der mindestens einen Signal- bzw. Versorgungsleitung 3, 4 ist nicht nur eine Leitungsüberwachung, sondern auch eine Störungslokalisierung möglich. Wird der Widerstand in der Signal- oder Versorgungsleitung 3, 4 an einer Stelle unzulässig hoch aufgrund, melden die dahinterliegenden Teilnehmer (Ansteuer- und Übermachungsmodule 1a, 1b) eine Störung, wohin gegen die vor der Störung liegenden Teilnehmer (Ansteuer- und Überwachungsmodule 1a, 1b) keine Störung melden. Auf diese Weise kann die Störung in der Stichleitung 3, 4 zur Energie- und Signalversorgung lokalisiert werden.

Beim Anlernvorgang werden bei den in den Zeichnungen schematisch dargestellten exemplarischen Ausführungsformen des erfindungsgemäßen Systems 20 alle Aktoren 2a, 2b gleichzeitig von der Systemsteuerung 21 angesteuert. Diese gleichzeitige Ansteuerung beim Anlernvorgang ist bevorzugt, um die gesamte Leistungsaufnahme des Systems 20 berücksichtigen zu können. Bei der Ausführung der Signalleitung 3 als Busleitung kann gemäß vielen Kommunikationsprotokollen eine gleichzeitige Ansteuerung mitteils eines sogenannten Broadcast-Befehls realisiert werden.

Ebenso erfolgt in einer bevorzugten Variante auch der Überwachungsmodus bei allen Ansteuer- und Überwachungsmodulen 1a, 1b gleichzeitig, indem die Systemsteuerung 21 alle Module 1a, 1b beispielsweise mitttels eines Broadcast-Befehls in den Überwachungsmodus überführt, in welchem wie vorstehend beschrieben eine im Anlernvorgang gemessene Strom- und/oder Leistungsaufnahme jedes Moduls 1a, 1b simuliert wird.

In einem Ansteuermodus hingegen werden alle Aktoren 2a, 2b des Systems 20 über die entsprechend zugeordneten Ansteuer- und Überwachungsmodule 1a, 1b nacheinander angesteuert, und zwar indem die Systemsteuerung 21 entweder alle Ansteuer- und Überwachungsmodule 1a, 1b nacheinander direkt anspricht oder einen Broadcast verteilt, den die Ansteuer- und Überwachungsmodule 1a, 1b mit einer jeweils zugeordneten zeitlichen Verzögerung umsetzen. Tritt bei diesem Szenario ein Kurzschluss an einem Aktor 2a, 2b des Systems 20 auf, erkennt das diesem Aktor 2a, 2b zugeordnete Ansteuer- und Überwachungsmodul 1a, 1b eine zu geringe Spannung oder einen zu hohen Stromfluss und trennt vorzugsweise den Aktor 2a, 2b sofort von der Energieversorgung. Zudem gibt das entsprechende Ansteuer- und Überwachungsmodul 1a, 1b eine Kurzschluss-Information über die Kommunikationseinrichtung 7 des Ansteuer- und Überwachungsmoduls 1a, 1b an die Systemsteuerung 21 ab.

Gemäß Ausführungsformen des erfindungsgemäßen Systems 20 werden einige Aktoren 2a, 2b dauerhaft angesteuert, was beispielsweise dann der Fall sein kann, wenn die Aktoren 2a, 2b als Leuchtfelder ausgebildet sind. Aufgrund der erfindungsgemäßen Ausgestaltung der Ansteuer- und Überwachungsmodule 1a, 1b kann für die weiteren Aktoren 2a, 2b dennoch gleichzeitig eine Leitungsüberwachung mithilfe der Ansteuereinrichtung 9, der Prüfeinrichtung 11 und der Messeinrichtung 8 umgesetzt werden.

In FIG. 2b ist schematisch eine weitere exemplarische Ausführungsform des erfindungsgemäßen Systems 20 dargestellt. Diese weitere exemplarische Ausführungsform des erfindungsgemäßen Systems 20 entspricht in struktureller und funktioneller Hinsicht im Wesentlichen dem im FIG. 2a gezeigten System 20, mit der Ausnahme, dass die einzelnen Ansteuer- und Überwachungsmodule 1a, 1b des Systems 20 nicht über eine gemeinsame Versorgungsleitung 4 mit vorzugsweise elektrischer Energie versorgt werden. Vielmehr ist bei der exemplarischen Ausführungsform gemäß FIG. 2b vorgesehen, dass die Ansteuer- und Überwachungsmodule 1a, 1b mit dezentralen Energieversorgungseinheiten 22 verbunden sind, wobei nicht nur wie in FIG. 2b gezeigt jedem Ansteuer- und Überwachungsmodul 1a, 1b eine eigene Energieversorgung zugeordnet sein kann, sondern sich auch mehrere Ansteuer- und Überwachungsmodule 1a, 1b mehrere gemeinsame Energieversorgungseinheiten 22 teilen können. Eine dezentrale Energieversorgung hat grundsätzlich den Vorteil verkürzter Leitungswege und damit eines geringeren Installations- und Wartungsaufwands.

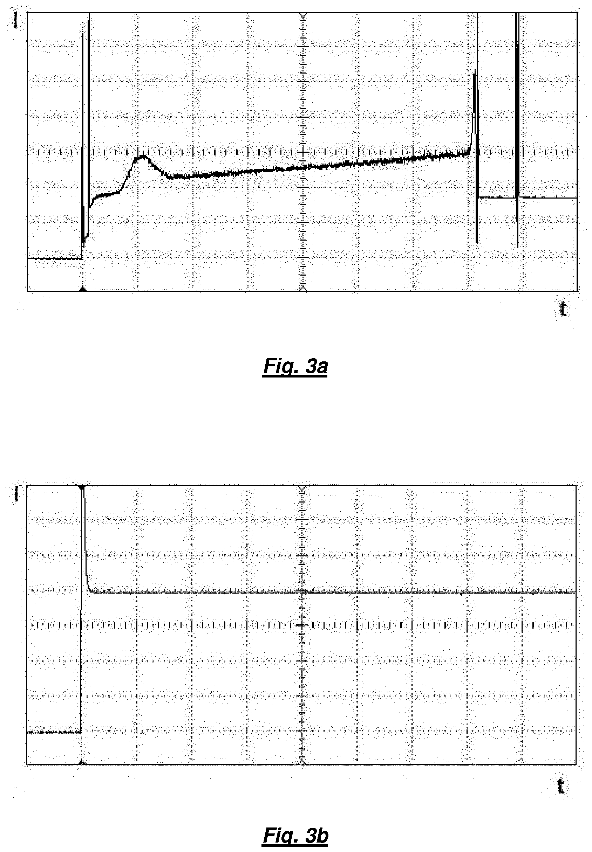

In den Figuren 3a bis 3e sind die zeitlichen Verläufe der Stromaufnahme von unterschiedlichen Aktoren 2a, 2b bei deren Betätigung gezeigt.

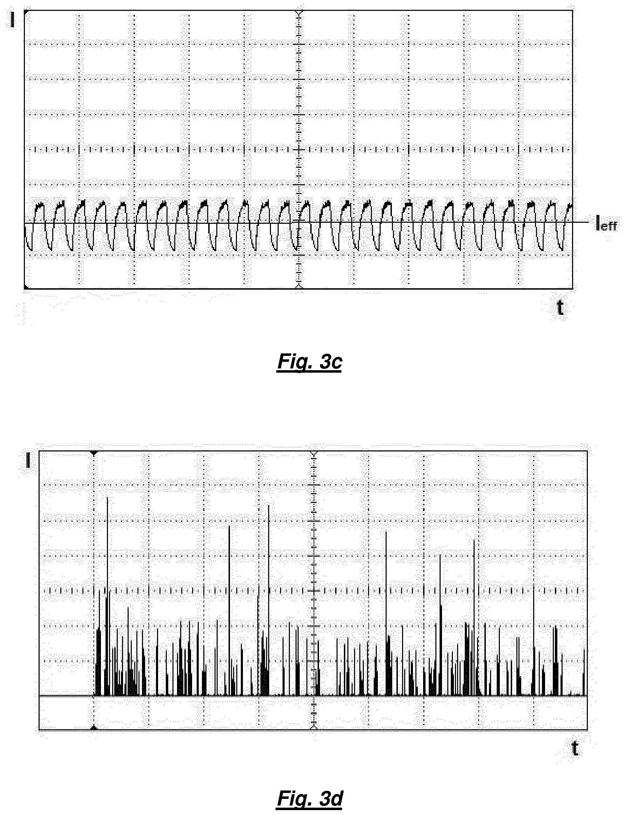

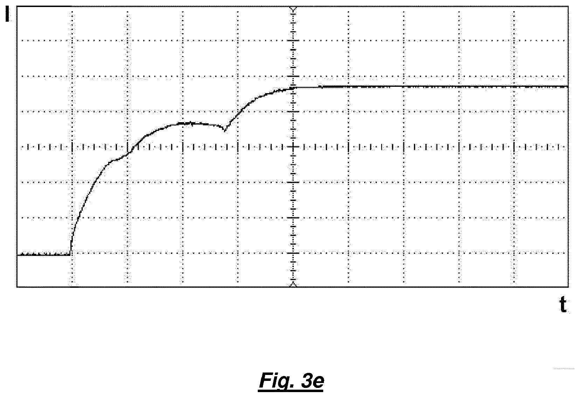

Im Einzelnen ist in
▪ FIG. 3a der zeitliche Verlauf der Stromaufnahme eines Stellantriebs;
▪ FIG. 3b der zeitliche Verlauf der Stromaufnahme einer Blitzleuchte;
▪ FIG. 3c der zeitliche Verlauf der Stromaufnahme eines Leuchtfeldes;
▪ FIG. 3d der zeitliche Verlauf der Stromaufnahme einer Sirene; und in
▪ FIG. 3e der zeitliche Verlauf der Stromaufnahme eines Ventils gezeigt.

Es ist ersichtlich, dass die unterschiedlichen Aktoren 2a, 2b eine charakteristische Strom- und/oder Leistungsaufnahme bei deren Aktivierung zeigen. Aufgrund der Komplexität der verschiedenen Charakteristika der Aktoren 2a, 2b ist es von daher bevorzugt, wenn die Messeinrichtungen 8 der jeweiligen Ansteuer- und Überwachungsmodule 1a, 1b des erfindungsgemäßen Systems 20, insbesondere in einem Anlernmodus des jeweiligen Ansteuer- und Überwachungsmoduls 1a, 1b, einen zeitlichen Verlauf einer Stromaufnahme des mindestens einen dem entsprechenden Ansteuerund Überwachungsmodul 1a, 1b zugeordneten Aktors 2a, 2b in seinem eingeschalteten Zustand und/oder einen zeitlichen Verlauf einer Leistungsaufnahme des mindestens einen dem jeweiligen Ansteuer- und Überwachungsmodul 1a, 1b zugeordneten Aktors 2a, 2b in seinem eingeschalteten Zustand ermitteln.

Insbesondere ist es bevorzugt, wenn die Messeinrichtung 8 in dem Anlernmodus einen Effektivwert der Strom- und/oder Leistungsaufnahme des Aktors 2a, 2b ermittelt, wobei die Prüfeinrichtung 11 ausgebildet ist, in dem Überwachungsmodus den ermittelten Effektivwert der Strom- und/oder Leistungsaufnahme des mindestens einen Aktors 2a, 2b zu simulieren. Unter einem Effektivwert wird derjenige Wert einer elektrischen Größe verstanden, der an einem Verbraucher in einer repräsentativen Zeitspanne, beispielsweise 10 bis 20 Sekunden, dieselbe elektrische Energie bzw. dieselbe elektrische Leistung umsetzt. In Figur 3c ist beispielhaft ein solcher Effektivwert I_{eff} als konstanter Ersatzwert für die über den Zeitverlauf gemessene Stromaufnahme eingezeichnet.

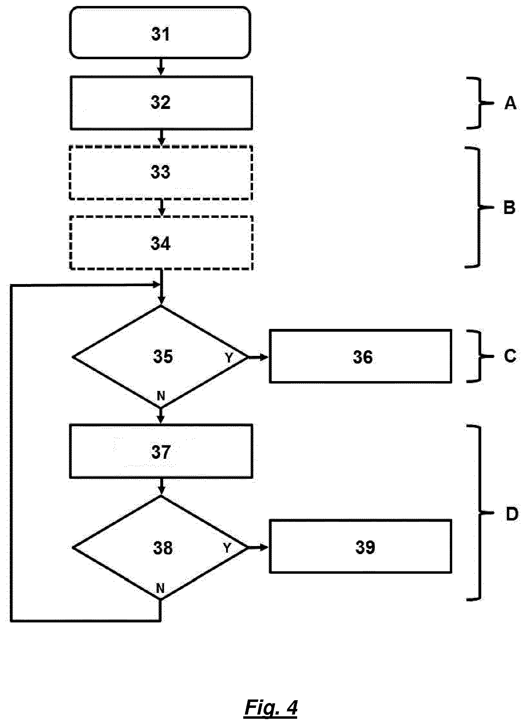

Nachfolgend wird unter Bezugnahme auf das Flussdiagramm gemäß FIG. 4 eine Ausführungsform des erfindungsgemäßen Verfahrens näher beschrieben.

Im Einzelnen ist in FIG. 4 schematisch der Ablauf eines Verfahrens zum Betreiben eines Ansteuerund Überwachungsmoduls 1; 1a, 1b zum Ansteuern mindestens eines dem Ansteuer- und Überwachungsmodul 1; 1a, 1b zugeordneten Aktors 2a, 2b und zum Überwachen mindestens einer Signal- und/oder Versorgungsleitung 3, 4 zu dem Ansteuer- und Überwachungsmodul 1; 1a, 1b und/oder zu dem mindestens einen Aktor 2a, 2b des Ansteuer- und Überwachungsmodul 1; 1a, 1b gezeigt.

Das Verfahren beginnt bevorzugt mit dem Schritt 31 der Inbetriebnahme oder Wartung des Ansteuerund Überwachungsmoduls 1; 1a, 1b bzw. des Systems 20. In einem Anlernmodus A steuert das Ansteuer- und Überwachungsmodul 1; 1a, 1b in Schritt 32 mittels einer Ansteuereinrichtung 9 den mindestens einen zugeordneten Aktor 2a, 2b an und misst die Strom- und/oder Leistungsaufnahme des aktivierten Aktors 2a, 2b mittels einer Messeinrichtung 8. In einem optionalen, sich sofort an den Anlernmodus A anschließenden Vorprüfmodus B simuliert die Prüfeinrichtung 11 des Ansteuer- und Überwachungsmoduls 1; 1a, 1b in Schritt 33 die soeben ermittelte Strom- und/oder Leistungsaufnahme des mindestens einen Aktors 2a, 2b. Dabei wird die an dem Ansteuer- und Überwachungsmodul und/oder dem mindestens einen Aktor anliegende Spannung ermittelt und bei Überschreiten eines vorab festgelegten oberen Spannungsschwellwerts oder bei Unterschreiten eines vorab festgelegten unteren Spannungsschwellwertes wird die simulierte Strom- und/oder Leistungsaufnahme in einem Schritt 34 bevorzugt automatisch nachgeregelt. Bei dieser Ausführungsform wird also zusätzlich überprüft, ob die angelernten bzw. die zur Simulation verwendeten Werte korrekt ermittelt wurden oder ob beispielsweise ein Messfehler oder ein Berechnungsfehler, etwa bei der Ermittlung des Effektivwertes, vorliegt. Hierbei wird davon ausgegangen, dass sich das System 20 während eines Anlernmodus A in einem intakten Zustand befindet, also insbesondere kein Defekt der Signal- und Energieversorgungsleitungen 3, 4 oder der Aktoren 2a, 2b vorliegt. Wird dennoch eine Störung aufgrund eines zu hohen oder zu niedrigen Spannungswertes gemeldet, kann die simulierte Strom- und/oder Leistungsaufnahme nach- bzw. feinjustiert, also nachgeregelt werden. Dies kann insbesondere automatisch, beispielsweise programmbasiert mit Unterstützung einer als Mikrocontroller ausgeführten Modulsteuerung 6, oder alternativ auch manuell vorgenommen werden.

In einem weiteren Betrieb des Ansteuer- und Überwachungsmoduls 1; 1a, 1b wird in Schritt 35 beispielsweise durch eine Modulsteuerung 6 kontinuierlich oder zyklisch überwacht, ob ein Ansteuerbefehl, beispielsweise von einer Systemsteuerung 21, vorliegt. Wird ein Ansteuerbefehl festgestellt, geht das Ansteuer- und Überwachungsmodul 1; 1a, 1b in einen Ansteuermodus C über, in welchem es die angeschlossenen Aktoren 2a, 2b beispielsweise durch Durchschalten einer Energieversorgung zu den Aktoren 2a, 2b ansteuert bzw. aktiviert. Wird kein Ansteuerbefehl festgestellt, geht das Ansteuer- und Überwachungsmodul 1; 1a, 1b in einen Überwachungsmodus D über. In diesem simuliert eine Prüfeinrichtung 11 in Schritt 37 die Strom- und/oder Leistungsaufnahme der angeschlossenen Aktoren 2a, 2b und misst die hierbei an dem Ansteuerund Überwachungsmodul 1; 1a, 1b und/oder die an den Aktoren 2a, 2b anliegende Spannung. In Schritt 38 des Überwachungsmodus vergleicht das Ansteuer- und Überwachungsmodul 1; 1a, 1b beispielsweise mithilfe einer Modulsteuerung 6 sowie einer integrierten Speichereinrichtung 12 die gemessenen Spannungswerte mit hinterlegten oberen und unteren Spannungsschwellwerten. Bei Überschreiten oder Unterschreiten eines Schwellwerts, insbesondere bei einem wiederholten oder aufeinanderfolgenden Über- bzw. Unterschreiten, setzt das Ansteuer- und Überwachungsmodul 1; 1a, 1b in einem Schritt 39 eine Störungsmeldung ab, beispielsweise über eine Kommunikationseinrichtung 7. Wird kein Über- oder Unterschreiten eines Schwellwerts festgestellt, kehrt das Ansteuer- und Überwachungsmodul 1 zu der in Schritt 35 erfolgenden Prüfung, ob ein Ansteuerbefehl vorliegt, zurück.

Die Erfindung ist nicht auf die in den Zeichnungen exemplarisch dargestellten Ausführungsformen beschränkt, sondern ergibt sich aus einer Zusammenschau sämtlicher hierin offenbarter Merkmale.

## Patentansprüche

1. Ansteuer- und Überwachungsmodul (1; 1a, 1b) zum Ansteuern mindestens eines dem Ansteuerund Überwachungsmodul (1; 1a, 1b) zugeordneten Aktors (2a, 2b) und zum Überwachen mindestens einer Signal- und/oder Versorgungsleitung (3, 4) zu dem Ansteuer- und Überwachungsmodul (1; 1a, 1b) und/oder zu dem mindestens einen Aktor (2a, 2b), wobei das Ansteuer- und Überwachungsmodul (1; 1a, 1b) Folgendes aufweist:
▪ eine Ansteuereinrichtung (9) zum Ansteuern des mindestens einen Aktors (2a, 2b);
▪ eine Messeinrichtung (8) zum Ermitteln einer Strom- und/oder Leistungsaufnahme des mindestens einen Aktors (2a, 2b) und zum Ermitteln einer an dem Ansteuer- und Überwachungsmodul (1; 1a, 1b) und/oder dem Aktor (2a, 2b) anliegenden Spannung; und
▪ eine Prüfeinrichtung (11) zum Simulieren einer Strom- und/oder Leistungsaufnahme des mindestens einen Aktors (2a, 2b),
**dadurch gekennzeichnet, dass** das Ansteuer- und Überwachungsmodul (1; 1a, 1b) ausgebildet ist, eine Störung der mindestens einen Signal- und/oder Versorgungsleitung (3, 4) zu erkennen, wenn bei einer von der Prüfeinrichtung (11) durchgeführten Simulation
▪ eine an dem Ansteuer- und Überwachungsmodul (1; 1a, 1b) und/oder dem Aktor (2a, 2b) anliegende Spannung einen vorab festgelegten oberen Spannungsschwellwert überschreitet oder einen vorab festgelegten unteren Spannungsschwellwert unterschreitet.

2. Ansteuer- und Überwachungsmodul (1; 1a, 1b) nach Anspruch 1, wobei das Ansteuer- und Überwachungsmodul (1; 1a, 1b) ferner ausgebildet ist, eine Störung der mindestens einen Signal- und/oder Versorgungsleitung (3, 4) zu erkennen, wenn bei einem Ansteuern des mindestens einen Aktors (2a, 2b):
▪ eine Stromaufnahme des mindestens einen Aktors (2a, 2b) einen vorab festgelegten oberen Stromschwellwert überschreitet oder einen vorab festgelegten unteren Stromschwellwert unterschreitet; und/oder
▪ eine Leistungsaufnahme des mindestens einen Aktors (2a, 2b) einen vorab festgelegten oberen Leistungsschwellwert überschreitet oder einen vorab festgelegten unteren Leistungsschwellwert unterschreitet; und/oder
▪ eine an dem Ansteuer- und Überwachungsmodul (1; 1a, 1b) und/oder dem Aktor (2a, 2b) anliegende Spannung einen vorab festgelegten oberen Spannungsschwellwert überschreitet oder einen vorab festgelegten unteren Spannungsschwellwert unterschreitet.

3. Ansteuer- und Überwachungsmodul (1; 1a, 1b) nach zumindest einem der Ansprüche 1 oder 2, wobei das Ansteuer- und Überwachungsmodul (1; 1a, 1b) ferner eine Speichereinrichtung (6) umfasst zum Speichern
▪ der ermittelten Strom- und/oder Leistungsaufnahme des mindestens einen Aktors (2a, 2b); und/oder
▪ der ermittelten an dem Ansteuer- und Überwachungsmodul (1; 1a, 1b) und/oder Aktor (2a, 2b) anliegenden Spannung; und/oder
▪ des vorab festgelegten oberen Stromschwellwerts und/oder des vorab festgelegten unteren Stromschwellwerts; und/oder
▪ des vorab festgelegten oberen Leistungsschwellwerts und/oder des vorab festgelegten unteren Leistungsschwellwerts; und/oder
▪ des vorab festgelegten oberen Spannungsschwellwerts und/oder des vorab festgelegten unteren Spannungsschwellwerts.

4. Ansteuer- und Überwachungsmodul (1; 1a, 1b) nach zumindest einem der Ansprüche 1 bis 3, wobei die Ansteuereinrichtung (9) ausgebildet ist, in einem Anlernmodus (A) und/oder Ansteuermodus (C) den mindestens einen Aktor (2a, 2b) anzusteuern und wobei die Messeinrichtung (8) ausgebildet ist, in dem Anlernmodus (A) und/oder Ansteuermodus (C) die Strom- und/oder Leistungsaufnahme des mindestens einen angesteuerten Aktors (2a, 2b) zu ermitteln; und/oder wobei die Prüfeinrichtung (11) ausgebildet ist, in einem Überwachungsmodus (D) die ermittelte Strom- und/oder Leistungsaufnahme des mindestens einen Aktors (2a, 2b) zu simulieren und wobei die Messeinrichtung (8) ausgebildet ist, in dem Überwachungsmodus (D) die an dem Ansteuer- und Überwachungsmodul (1; 1a, 1b) und/oder dem mindestens einen Aktor (2a, 2b) anliegende Spannung zu ermitteln.

5. Ansteuer- und Überwachungsmodul (1; 1a, 1b) nach Anspruch 4, wobei die Messeinrichtung (8) ausgebildet ist, in einem Anlernmodus (A) und/oder Ansteuermodus (C) ferner die an dem Ansteuer- und Überwachungsmodul (1; 1a, 1b) und/oder dem mindestens einen Aktor (2a, 2b) anliegende Spannung zu ermitteln.

6. Ansteuer- und Überwachungsmodul (1; 1a, 1b) nach zumindest einem der Ansprüche 4 oder 5, wobei die Messeinrichtung (8) ausgebildet ist, in dem Anlernmodus (A) einen zeitlichen Verlauf und/oder einen Effektivwert (I_{eff}) der Strom- und/oder Leistungsaufnahme des Aktors (2a, 2b) zu ermitteln und wobei die Prüfeinrichtung (11) ausgebildet ist, in dem Überwachungsmodus (D) den ermittelten Effektivwert (I_{eff}) oder den ermittelten zeitlichen Verlauf der Strom- und/oder Leistungsaufnahme des mindestens einen Aktors (2a, 2b) zu simulieren.

7. Ansteuer- und Überwachungsmodul (1; 1a, 1b) nach zumindest einem der Ansprüche 1 bis 6, wobei das Ansteuer- und Überwachungsmodul (1; 1a, 1b) ferner eine Kommunikationseinrichtung (7) aufweist, über welche das Ansteuer- und Überwachungsmodul (1; 1a, 1b) mit einer Systemsteuerung (21) kommunikativ verbunden oder verbindbar ist.

8. System (20) welches Folgendes aufweist:
▪ mindestens einen Aktor (2a, 2b);
▪ eine Systemsteuerung (21) zur Versorgung des Aktors (2a, 2b) mit Signalen;
▪ eine Energieversorgungseinrichtung (22) zur Versorgung des Aktors (2a, 2b) mit elektrischer Energie;
▪ mindestens eine Signal- und/oder Versorgungsleitung (3, 4), welche zwischen der Systemsteuerung (21) und/oder der Energieversorgungseinrichtung (22) und dem mindestens einen Aktor (2a, 2b) verläuft;
**dadurch gekennzeichnet, dass** dem mindestens einen Aktor (2a, 2b) ein Ansteuer- und Überwachungsmodul (1; 1a, 1b) nach zumindest einem der Ansprüche 1 bis 7 zugeordnet ist, wobei das Ansteuer- und Überwachungsmodul (1; 1a, 1b) ausgebildet ist, die mindestens eine Signal- und/oder Versorgungsleitung (3, 4) auf Störung zu überwachen und/oder den mindestens einen Aktor (2a, 2b) anzusteuern und/oder die Ansteuerung des mindestens einen Aktors (2a, 2b) zu simulieren.

9. System (20) nach Anspruch 8, wobei die Systemsteuerung (21) ausgebildet ist, das dem mindestens einen Aktor (2a, 2b) zugeordnete Ansteuer- und Überwachungsmodul (1; 1a, 1b) in einen Anlernmodus (A) zu überführen, in welchem der mindestens eine Aktor (2a, 2b), angesteuert und die Strom- und/oder Leistungsaufnahme des mindestens einen Aktors (2a, 2b) ermittelt wird.

10. System (20) nach Anspruch 9, wobei in dem Anlernmodus (A) ferner die an dem Ansteuer- und Überwachungsmodul (1; 1a, 1b) und/oder dem mindestens einem Aktor (2a, 2b) anliegende Spannung ermittelt wird.

11. System (20) nach zumindest einem der Ansprüche 8 bis 10, wobei die Systemsteuerung (21) ausgebildet ist, das dem mindestens einen Aktor (2a, 2b) zugeordnete Ansteuer- und Überwachungsmodul (1; 1a, 1b) in einen Vorprüfmodus (B) zu überführen, in welchem das dem mindestens einen Aktor (2a, 2b) zugeordnete Ansteuer- und Überwachungsmodul (1; 1a, 1b) die Strom- und/oder Leistungsaufnahme des mindestens einen Aktors (2a, 2b) simuliert, die an dem Ansteuer- und Überwachungsmodul (1; 1a, 1b) und/oder dem mindestens einen Aktor (2a, 2b) anliegende Spannung ermittelt wird und bei Überschreiten eines vorab festgelegten oberen Spannungsschwellwerts oder bei Unterschreiten eines vorab festgelegten unteren Spannungsschwellwertes die simulierte Strom- und/oder Leistungsaufnahme bevorzugt automatisch nachgeregelt wird.

12. System (20) nach zumindest einem der Ansprüche 8 bis 11, wobei die Systemsteuerung (21) ausgebildet ist, das dem mindestens einen Aktor (2a, 2b) zugeordnete Ansteuer- und Überwachungsmodul (1; 1a, 1b) in einen Überwachungsmodus (D) zu überführen, in welchem das dem mindestens einen Aktor (2a, 2b) zugeordnete Ansteuer- und Überwachungsmodul (1; 1a, 1b) die Strom- und/oder Leistungsaufnahme des mindestens einen Aktors (2a, 2b) simuliert und die am Ansteuer- und Überwachungsmodul (1; 1a, 1b) und/oder dem mindestens einen Aktor (2a, 2b) anliegende Spannung ermittelt wird; und wobei das Ansteuer- und Überwachungsmodul (1; 1a, 1b) ausgebildet ist, eine Störung der mindestens einen Signal- und/oder Versorgungsleitung (3, 4) zu erkennen, wenn bei einer Simulation eine an dem Ansteuer- und Überwachungsmodul (1; 1a, 1b) und/oder dem Aktor (2a, 2b) anliegende Spannung einen vorab festgelegten oberen Spannungsschwellwert überschreitet oder einen vorab festgelegten unteren Spannungsschwellwert unterschreitet.

13. System (20) nach zumindest einem der Ansprüche 8 bis 12, wobei die Systemsteuerung (21) ausgebildet ist, das dem mindestens einen Aktor (2a, 2b) zugeordnete Ansteuer- und Überwachungsmodul (1; 1a, 1b) in einen Ansteuermodus (C) zu überführen, in welchem das Ansteuer- und Überwachungsmodul (1; 1a, 1b) den mindestens einen Aktor (2a, 2b) ansteuert.

14. System (20) nach zumindest einem der Ansprüche 8 bis 13, wobei mindestens zwei Ansteuerund Überwachungsmodule (1; 1a, 1b) mit jeweils mindestens einem Aktor (2a, 2b) vorgesehen sind und wobei die Systemsteuerung (21) ausgebildet ist, bei einem von einer Messeinrichtung (8) mindestens eines der Ansteuer- und Überwachungsmodule (1; 1a, 1b) festgestellten Überschreiten oder Unterschreiten eines oberen oder unteren Strom-, Leistungs- und/oder Spannungsschwellwerts eine Störung der mindestens einen Signal- und/oder Versorgungsleitung (3, 4) festzustellen sowie bevorzugt eine Lokalisierung der Störung in dem System (20) durchzuführen.

15. Verfahren zum Betreiben eines Ansteuer- und Überwachungsmoduls (1; 1a, 1b) nach zumindest einem der Ansprüche 1 bis 7, zum Ansteuern mindestens eines dem Ansteuer- und Überwachungsmodul (1; 1a, 1b) zugeordneten Aktors (2a, 2b) und zum Überwachen mindestens einer Signal- und/oder Versorgungsleitung (3, 4) zu dem Ansteuer- und Überwachungsmodul (1; 1a, 1b) und/oder zu dem mindestens einen Aktor (2a, 2b) **dadurch gekennzeichnet, dass** das Verfahren die folgenden Verfahrensschritte aufweist:
a) Ansteuern des mindestens einen Aktors (2a, 2b) und Ermitteln einer Strom- und/oder Leistungsaufnahme des mindestens einen Aktors (2a, 2b) in einem Anlernmodus (A);
b) Simulieren der im Anlernmodus (A) ermittelten Strom- und/oder Leistungsaufnahme des mindestens einen Aktors (2a, 2b) in einem Überwachungsmodus (D) und Ermitteln der an dem Ansteuer- und Überwachungsmodul (1; 1a, 1b) und/oder an dem Aktor (2a, 2b) anliegenden Spannung in dem bevorzugt zyklisch eingeleiteten Überwachungsmodus (D);
c) Erkennen einer Störung der mindestens einen Signal- und/oder Versorgungsleitung (3, 4), wenn bei der von der Prüfeinrichtung (11) des Ansteuer- und Überwachungsmoduls (1; 1a, 1b) durchgeführten Simulation in dem Überwachungsmodus (D) die an dem Ansteuer- und Überwachungsmodul (1; 1a, 1b) und/oder an dem Aktor (2a, 2b) anliegende Spannung einen vorab festgelegten oberen Spannungsschwellwert überschreitet oder einen vorab festgelegten unteren Spannungsschwellwert unterschreitet;
d) Ansteuern des mindestens einen Aktors (2a, 2b) in einem bedarfsweise eingeleiteten Ansteuermodus (C).

## Claims

1. A control and monitoring module (1; 1a, 1b) for controlling at least one actuator (2a, 2b) associated with the control and monitoring module (1; 1a, 1b) and for monitoring at least one signal and/or supply line (3, 4) to the control and monitoring module (1; 1a, 1b) and/or to the at least one actuator (2a, 2b), wherein the control and monitoring module (1; 1a, 1b) comprises the following:
* a control unit (9) for controlling the at least one actuator (2a, 2b);
* a measuring unit (8) for measuring a current draw and/or power consumption of the at least one actuator (2a, 2b) and for measuring a voltage across the control and monitoring module (1; 1a, 1b) and/or the actuator (2a, 2b); and
* a testing unit (11) for simulating a current draw and/or power consumption of the at least one actuator (2a, 2b),
**characterised in that** the control and monitoring module (1; 1a, 1b) is designed to detect a fault in the at least one signal and/or supply line (3, 4) if, during a simulation carried out by the testing unit (11)
* a voltage across the control and monitoring module (1; 1a, 1b) and/or the actuator (2a, 2b) exceeds a predefined upper voltage threshold or falls below a predefined lower voltage threshold.

2. The control and monitoring module (1; 1a, 1b) according to claim 1, wherein the control and monitoring module (1; 1a, 1b) is further designed to detect a fault in the at least one signal and/or supply line (3, 4), if, when controlling the at least one actuator (2a, 2b):
* a current draw of the at least one actuator (2a, 2b) exceeds a predefined upper current threshold or falls below a predefined lower current threshold; and/or
* a power consumption of the at least one actuator (2a, 2b) exceeds a predefined upper power consumption threshold or falls below a predefined lower power consumption threshold; and/or
* a voltage across the control and monitoring module (1; 1a, 1b) and/or the actuator (2a, 2b) exceeds a predefined upper voltage threshold or falls below a predefined lower voltage threshold.

3. The control and monitoring module (1; 1a, 1b) according to at least one of claims 1 or 2, wherein the control and monitoring module (1; 1a, 1b) further includes a memory storage device (6) for storing:
* the determined current draw and/or power consumption of the at least one actuator (2a, 2b); and/or
* the determined voltage across the control and monitoring module (1; 1a, 1b) and/or the actuator (2a, 2b); and/or
* the predefined upper current threshold and/or the predefined lower current threshold; and/or
* the predefined upper power consumption threshold and/or the predefined lower power consumption threshold; and/or
* the predefined upper voltage threshold and/or the predefined lower voltage threshold.

4. The control and monitoring module (1; 1a, 1b) according to at least one of claims 1 to 3, wherein the control unit (9) is designed, in a learning mode (A) and/or an activation mode (C), to activate the at least one actuator (2a, 2b), and wherein the measuring unit (8) is designed in the learning mode (A) and/or the activation mode (C) to determine the current draw and/or power consumption of the at least one activated actuator (2a, 2b); and/or wherein the testing unit (11) is designed, in a monitoring mode (D), to simulate the determined current draw and/or power consumption of the at least one actuator (2a, 2b), and wherein the measuring unit (8) is designed in the monitoring mode (D) to determine the voltage across the control and monitoring module (1; 1a, 1b) and/or the at least one actuator (2a, 2b).

5. The control and monitoring module (1; 1a, 1b) according to claim 4, wherein the measuring unit (8) is designed in a learning mode (A) and/or the activation mode (C) also to determine the voltage across the control and monitoring module (1; 1a, 1b) and/or at the at least one actuator (2a, 2b).

6. The control and monitoring module (1; 1a, 1b) according to at least one of claims 4 or 5, wherein the measuring unit (8) is designed in the learning mode (A) to determine a time profile and/or an effective value (I_{eff}) of the current draw and/or power consumption of the actuator (2a, 2b), and wherein the testing unit (11) is designed to simulate in the monitoring mode (D) the effective value (I_{eff}) or the time profile of the current draw and/or power consumption of the at least one actuator (2a, 2b).

7. The control and monitoring module (1; 1a, 1b) according to at least one of claims 1 to 6, wherein the control and monitoring module (1; 1a, 1b) further comprises a communication device (7), via which the control and monitoring module (1; 1a, 1b) is or can be connected to a system control (21).

8. A system (20) which has the following:
* at least one actuator (2a, 2b);
* a system control (21) for supplying the actuator (2a, 2b) with signals;
* a power supply unit (22) for supplying the actuator (2a, 2b) with electrical energy;
* at least one signal and/or supply line (3, 4) which runs between the system control (21) and/or the power supply unit (22) and the at least one actuator (2a, 2b);
**characterised in that** a control and monitoring module (1; 1a, 1b) according to at least one of claims 1 to 7 is associated with the at least one actuator (2a, 2b), wherein the control and monitoring module (1; 1a, 1b) is designed to monitor the at least one signal and/or supply line (3, 4) for faults and/or to activate the at least one actuator (2a, 2b) and/or to simulate the activation of the at least one actuator (2a, 2b).

9. The system (20) according to claim 8, wherein the system control (21) is designed to switch the control and monitoring module (1; 1a, 1b) associated with the at least one actuator (2a, 2b) into a learning mode (A), in which the at least one actuator (2a, 2b) is activated and the current draw and/or power consumption of the at least one actuator (2a, 2b) is determined.

10. The system (20) according to claim 9, wherein, in the learning mode (A), the voltage across the control and monitoring module (1; 1a, 1b) and/or the at least one actuator (2a, 2b) is also determined.

11. The system (20) according to at least one of claims 8 to 10, wherein the system control (21) is designed to switch the control and monitoring module (1; 1a, 1b) associated with the at least one actuator (2a, 2b) into a pre-test mode (B) in which the control and monitoring module (1; 1a, 1b) associated with the at least one actuator (2a, 2b) simulates the current draw and/or power consumption of the at least one actuator (2a, 2b), the voltage across the control and monitoring module (1; 1a, 1b) and/or the at least one actuator (2a, 2b) is determined and, if exceeding a predefined upper voltage threshold or falling below a predefined lower voltage threshold, the simulated current draw and/or power consumption is preferably readjusted automatically.

12. The system (20) according to at least one of claims 8 to 11, wherein the system control (21) is designed to switch the control and monitoring module (1; 1a, 1b) associated with the at least one actuator (2a, 2b) into a monitoring mode (D) in which the control and monitoring module (1; 1a, 1b) associated with the at least one actuator (2a, 2b) simulates the current draw and/or power consumption of the at least one actuator (2a, 2b) and the voltage across the control and monitoring module (1; 1a, 1b) and/or the at least one actuator (2a, 2b) is determined; and wherein the control and monitoring module (1; 1a, 1b) is designed to detect a fault in the at least one signal and/or supply line (3, 4), if, during a simulation, a voltage at the control and monitoring module (1; 1a, 1b) and/or the actuator (2a,2b) exceeds a predefined upper voltage threshold or falls below a predefined lower voltage threshold.

13. The system (20) according to at least one of claims 8 to 12, wherein the system control (21) is designed to switch the control and monitoring module (1; 1a, 1b) associated with the at least one actuator (2a, 2b) into an activation mode (C) in which the control and monitoring module (1; 1a, 1b) activates the at least one actuator (2a, 2b).

14. The system (20) according to at least one of claims 8 to 13, wherein at least two control and monitoring modules (1; 1a, 1b) are provided each with at least one actuator (2a, 2b), and wherein the system control (21) is designed, when a measuring unit (8) of at least one of the control and monitoring modules (1; 1a, 1b) establishes a current, power, and/or voltage exceeding or falling below an upper or lower current, power, and/or voltage threshold, to establish a fault in the at least one signal and/or supply line (3, 4), and preferably localise the fault in the system (20).

15. A method for operating a control and monitoring module (1; 1a, 1b) according to at least one of claims 1 to 7, for controlling at least one actuator (2a, 2b) associated with the control and monitoring modules (1; 1a, 1b) and for monitoring at least one signal and/or supply line (3, 4) to the control and monitoring module (1; 1a, 1b) and/or to the at least one actuator (2a, 2b), **characterised in that** the method comprises the following method steps :
a) activating the at least one actuator (2a, 2b) and determining a current draw and/or power consumption of the at least one actuator (2a, 2b) in a learning mode (A);
b) simulating the current draw and/or power consumption determined in the learning mode (A) of the at least one actuator (2a, 2b), in a monitoring mode (D) and determining the voltage across the control and monitoring module (1; 1a, 1b) and/or the actuator (2a, 2b) in the preferred cyclically initiated monitoring mode (D);
c) detecting a fault in the at least one signal and/or supply line (3,4) if, during the simulation carried out in the monitoring mode (D) with the testing unit (11) of the control and monitoring module (1; 1a, 1b) the voltage across the control and monitoring module (1; 1a, 1b) and/or the actuator (2a, 2b) exceeds a predefined upper voltage threshold or falls below a predefined lower voltage threshold;
d) activating the at least one actuator (2a, 2b) in an activation mode (C) as needed.

## Revendications

1. Module de commande et de surveillance (1 ; 1a, 1b) pour la commande d'au moins un actionneur (2a, 2b) associé au module de commande et de surveillance (1 ; 1a, 1b) et pour la surveillance d'au moins une ligne de signaux et/ou d'alimentation (3, 4) connectée au module de commande et de surveillance (1 ; 1a, 1b) et/ou audit au moins un actionneur (2a, 2b), dans lequel le module de commande et de surveillance (1 ; 1a, 1b) comprend les moyens suivants :
▪ un dispositif de commande (9) pour commander ledit au moins un actionneur (2a, 2b) ;
▪ un dispositif de mesure (8) pour déterminer une consommation de courant et/ou de puissance dudit au moins un actionneur (2a, 2b) et pour déterminer une tension appliquée au module de commande et de surveillance (1 ; 1a, 1b) et/ou à l'actionneur (2a, 2b) ; et
▪ un dispositif de test (11) pour simuler une consommation de courant et/ou de puissance dudit au moins un actionneur (2a, 2b),
**caractérisé en ce que** le module de commande et de surveillance (1 ; 1a, 1b) est conçu pour détecter un défaut dans ladite au moins une ligne de signaux et/ou d'alimentation (3, 4) si, lors d'une simulation effectuée par le dispositif de test (11)
▪ une tension appliquée au module de contrôle et de surveillance (1 ; 1a, 1b) et/ou à l'actionneur (2a, 2b) dépasse une valeur seuil de tension supérieure prédéterminée ou tombe en dessous d'une valeur seuil de tension inférieure prédéterminée.

2. Module de commande et de surveillance (1 ; 1a, 1b) selon la revendication 1, dans lequel le module de commande et de surveillance (1 ; 1a, 1b) est en outre conçu pour détecter un défaut dans ladite au moins une ligne de signaux et/ou d'alimentation (3, 4) si, lors d'une commande dudit au moins un actionneur (2a, 2b) :
▪ une consommation de courant dudit au moins un actionneur (2a, 2b) dépasse une valeur seuil supérieure de courant prédéterminée ou tombe en dessous d'une valeur seuil inférieure de courant prédéterminée ; et/ou
▪ une consommation de puissance dudit au moins un actionneur (2a, 2b) dépasse une valeur seuil de puissance supérieure prédéterminée ou tombe en dessous d'une valeur seuil de puissance inférieure prédéterminée ; et/ou
▪ une tension appliquée au module de contrôle et de surveillance (1 ; 1a, 1b) et/ou à l'actionneur (2a, 2b) dépasse une valeur seuil de tension supérieure prédéterminée ou tombe en dessous d'une valeur seuil de tension inférieure prédéterminée.

3. Module de commande et de surveillance (1 ; 1a, 1b) selon l'une au moins des revendications 1 ou 2, dans lequel le module de commande et de surveillance (1 ; 1a, 1b) comprend en outre un dispositif de mémoire (6) pour stocker
▪ la consommation déterminée de courant et/ou de puissance dudit au moins un actionneur (2a, 2b) ; et/ou
▪ la tension déterminée appliquée au module de commande et de surveillance (1 ; 1a, 1b) et/ou à l'actionneur (2a, 2b) ; et/ou
▪ la valeur seuil supérieure de courant prédéterminée et/ou la valeur seuil inférieure de courant prédéterminée ; et/ou
▪ la valeur seuil de puissance supérieure prédéterminée et/ou la valeur seuil de puissance inférieure prédéterminée ; et/ou
▪ la valeur seuil de tension supérieure prédéterminée et/ou la valeur seuil de tension inférieure prédéterminée.

4. Module de commande et de surveillance (1 ; 1a, 1b) selon l'une au moins des revendications 1 à 3, dans lequel le dispositif de commande (9) est configuré pour commander ledit au moins un actionneur (2a, 2b) dans un mode d'apprentissage (A) et/ou un mode de commande (C) et dans lequel le dispositif de mesure (8) est conçu pour déterminer la consommation de courant et/ou de puissance dudit au moins un actionneur (2a, 2b) commandé dans le mode d'apprentissage (A) et/ou le mode de commande (C) ; et/ou dans lequel le dispositif de test (11) est conçu pour simuler la consommation de courant et/ou de puissance déterminée dudit au moins un actionneur (2a, 2b) dans un mode de surveillance (D), et dans lequel le dispositif de mesure (8) est conçu pour déterminer la tension appliquée au module de commande et de surveillance (1 ; 1a, 1b) et/ou audit au moins un actionneur (2a, 2b) dans le mode de surveillance (D).

5. Module de commande et de surveillance (1 ; 1a, 1b) selon la revendication 4, dans lequel le dispositif de mesure (8) est conçu pour déterminer en outre la tension appliquée au module de commande et de surveillance (1 ; 1a, 1b) et/ou audit au moins un actionneur (2a, 2b) dans un mode d'apprentissage (A) et/ou un mode de commande (C).

6. Module de commande et de surveillance (1 ; 1a, 1b) selon l'une au moins des revendications 4 ou 5, dans lequel le dispositif de mesure (8) est conçu pour déterminer une courbe temporelle et/ou une valeur effective (I_{eff}) de la consommation de courant et/ou de puissance de l'actionneur (2a, 2b) dans le mode d'apprentissage (A), et dans lequel le dispositif de test (11) est conçu pour simuler la valeur effective déterminée (I_{eff} ) ou la courbe temporelle déterminée de la consommation de courant et/ou de puissance dudit au moins un actionneur (2a, 2b) dans le mode de surveillance (D).

7. Module de commande et de surveillance (1 ; 1a, 1b) selon l'une au moins des revendications 1 à 6, dans lequel le module de commande et de surveillance (1 ; 1a, 1b) comprend en outre un dispositif de communication (7), par lequel le module de commande et de surveillance (1 ; 1a, 1b) est relié ou peut être relié à un système de commande (21).

8. Système (20) qui comporte les moyens suivants :
▪ au moins un actionneur (2a, 2b) ;
▪ un système de commande (21) pour alimenter l'actionneur (2a, 2b) en signaux ;
▪ un dispositif d'alimentation en énergie (22) pour alimenter l'actionneur (2a, 2b) en énergie électrique ;
▪ au moins une ligne de signaux et/ou d'alimentation (3, 4) qui relie le système de commande (21) et/ou le dispositif d'alimentation en énergie (22) avec ledit au moins un actionneur (2a, 2b),
**caractérisé en ce qu'**un module de commande et de surveillance (1 ; 1a, 1b) selon l'une au moins des revendications 1 à 7 est associé audit au moins un actionneur (2a, 2b), dans lequel le module de commande et de surveillance (1 ; 1a, 1b) est conçu pour surveiller la présence de défauts sur ladite au moins une ligne de signaux et/ou d'alimentation (3, 4) et/ou pour commander ledit au moins un actionneur (2a, 2b) et/ou pour simuler la commande dudit au moins un actionneur (2a, 2b).

9. Système (20) selon la revendication 8, dans lequel le système de commande (21) est conçu pour passer le module de commande et de surveillance (1 ; 1a, 1b) associé audit au moins un actionneur (2a, 2b) dans un mode d'apprentissage (A), dans lequel on commande ledit au moins un actionneur (2a, 2b) et on détermine la consommation de courant et/ou de puissance dudit au moins un actionneur (2a, 2b).

10. Système (20) selon la revendication 9, dans lequel, dans le mode d'apprentissage (A), on détermine également la tension appliquée au module de commande et de surveillance (1 ; 1a, 1b) et/ou audit au moins un actionneur (2a, 2b).

11. Système (20) selon l'une au moins des revendications 8 à 10, dans lequel le système de commande (21) est conçu pour passer le module de commande et de surveillance (1 ; 1a, 1b) associé audit au moins un actionneur (2a, 2b) dans un mode de test préliminaire (B), dans lequel le module de commande et de surveillance (1 ; 1a, 1b) associé audit au moins un actionneur (2a, 2b) simule la consommation de courant et/ou de puissance dudit au moins un actionneur (2a, 2b), détermine la tension appliquée au module de commande et de surveillance (1 ; 1a, 1b) et/ou audit au moins un actionneur (2a, 2b) et, si on dépasse une valeur seuil de tension supérieure prédéterminée ou si on tombe en dessous d'une valeur seuil de tension inférieure prédéterminée, la consommation de courant et/ou de puissance simulée est de préférence réajustée automatiquement.

12. Système (20) selon l'une au moins des revendications 8 à 11, dans lequel le système de commande (21) est conçu pour passer le module de commande et de surveillance (1 ; 1a, 1b) associé audit au moins un actionneur (2a, 2b) dans un mode de surveillance (D), dans lequel le module de commande et de surveillance (1 ; 1a, 1b) associé audit au moins un actionneur (2a, 2b) simule la consommation de courant et/ou de puissance dudit au moins un actionneur (2a, 2b) et détermine la tension appliquée au module de commande et de surveillance (1 ; 1a, 1b) et/ou audit au moins un actionneur (2a, 2b) ; et dans lequel le module de commande et de surveillance (1 ; 1a, 1b) est conçu pour détecter un défaut dans au moins une ligne de signaux et/ou d'alimentation (3, 4) si, pendant une simulation, une tension appliquée au module de commande et de surveillance (1 ; 1a, 1b) et/ou à l'actionneur (2a, 2b) dépasse une valeur seuil de tension supérieure prédéterminée ou tombe en dessous d'une valeur seuil de tension inférieure prédéterminée.

13. Système (20) selon l'une au moins des revendications 8 à 12, dans lequel le système de commande (21) est conçu pour passer le module de commande et de surveillance (1 ; 1a, 1b) associé audit au moins un actionneur (2a, 2b) dans un mode de commande (C) dans lequel le module de commande et de surveillance (1 ; 1a, 1b) commande ledit au moins un actionneur (2a, 2b).

14. Système (20) selon l'une au moins des revendications 8 à 13, dans lequel sont prévus au moins deux modules de commande et de surveillance (1 ; 1a, 1b) comportant chacun au moins un actionneur (2a, 2b) et dans lequel le système de commande (21) est conçu pour détecter un défaut dans ladite au moins une ligne de signaux et/ou d'alimentation (3, 4) et de préférence pour localiser le défaut dans le système (20) lorsqu'un dispositif de mesure (8) détecte qu'au moins un des modules de commande et de surveillance (1 ; 1a, 1b) dépasse une valeur seuil supérieure ou tombe en dessous d'une valeur seuil inférieure de courant, de puissance et/ou de tension.

15. Procédé pour faire fonctionner un module de commande et de surveillance (1 ; 1a, 1b) selon l'une au moins des revendications 1 à 7, pour commander au moins l'un des actionneurs (2a, 2b) associés au module de commande et de surveillance (1 ; 1a, 1b) et pour surveiller au moins une ligne de signaux et/ou d'alimentation (3, 4) conduisant vers le module d'entraînement et de surveillance (1 ; 1a, 1b) et/ou vers ledit au moins un actionneur (2a, 2b), **caractérisé en ce que** le procédé comporte les étapes de procédé suivantes :
a) commander au moins un actionneur (2a, 2b) et déterminer la consommation de courant et/ou de puissance dudit au moins un actionneur (2a, 2b) dans un mode d'apprentissage (A) ;
b) simuler dans un mode de surveillance (D) la consommation de courant et/ou de puissance dudit au moins un actionneur (2a, 2b) déterminée en mode d'apprentissage (A) et déterminer la tension appliquée au module de commande et de surveillance (1 ; 1a, 1b) et/ou à l'actionneur (2a, 2b) dans le mode de surveillance (D) qui est de préférence déclenché de manière cyclique ;
c) détecter un défaut dans au moins une ligne de signaux et/ou d'alimentation (3, 4) si, pendant une simulation réalisée par le dispositif de test (11) du module de commande et de surveillance (1 ; 1a, 1b) au cours du mode de surveillance (D), la tension appliquée au module de commande et de surveillance (1 ; 1a, 1b) et/ou à l'actionneur (2a, 2b) dépasse une valeur seuil de tension supérieure prédéterminée ou tombe en dessous d'une valeur seuil de tension inférieure prédéterminée ;
d) commander ledit au moins un actionneur (2a, 2b) dans un mode de commande (C) déclenché selon les besoins.
